# EUROPÄISCHE PATENTSCHRIFT

(11) **EP 3 574 512 B1**
(45) Veröffentlichungstag und Bekanntmachung des Hinweises auf die Patenterteilung: **26.08.2020**
(21) Anmeldenummer: 18701735.5
(22) Anmeldetag: 24.01.2018
(51) Int. Cl.: H01F 38/14, H01F 27/02, H05K 5/04, H02J 7/02, H02J 5/00, G12B 9/02, F16J 15/02, B60L 53/12

(54) **EMPFANGSVORRICHTUNG UND VERFAHREN ZUR HERSTELLUNG**
RECEIVING DEVICE AND METHOD OF PRODUCING THE SAME
DISPOSITIF DE RÉCEPTION ET SON PROCÉDÉ DE FABRICATION

(30) Priorität: 26.01.2017 DE 102017101583
(43) Veröffentlichungstag der Anmeldung: 04.12.2019
(73) Patentinhaber: Bombardier Primove GmbH, 10785 Berlin (DE)
(72) Erfinder: WECHSLER, Simon, 69493 Hirschberg (DE); GUNT, Roman, 69120 Heidelberg (DE)
(74) Vertreter: Ramrath, Lukas
(86) Internationale Anmeldenummer: PCT/EP2018/051685
(87) Internationale Veröffentlichungsnummer: WO 2018/138127

(56) Entgegenhaltungen:
- EP-A1- 1 391 640
- EP-A1- 2 618 344
- WO-A1-2014/166963
- WO-A2-2015/150297
- DE-A1- 3 107 455
- DE-A1-102012 202 472

## Beschreibung

Die Erfindung betrifft eine Empfangsvorrichtung für ein System zur induktiven Leistungsübertragung sowie ein Verfahren zur Herstellung einer solchen Empfangsvorrichtung. Insbesondere betrifft die Erfindung eine Empfangsvorrichtung zum Empfang eines elektromagnetischen Feldes und zum induktionsbasierten Bereitstellen elektrischer Energie, insbesondere für die Nutzung durch ein Fahrzeug, weiter insbesondere durch ein Automobil.

Eine Anwendung der Erfindung kann insbesondere im Bereich der drahtlosen Energieübertragung zu Fahrzeugen, wie z.B. Automobilen, Bussen, Vans, Lastkraftwagen, Gabelstaplern und Schienenfahrzeugen, liegen. Die Empfangsvorrichtung kann hierfür insbesondere zur Bereitstellung von elektrischer Leistung im Bereich mehrerer Kilowatt, z.B. 20 kW, sein.

Während einer Fahrt auf einer Fahrbahn kann ein Fahrzeug Energie zum Antrieb und für den Betrieb von Zusatzeinrichtungen, die nicht zum Antrieb des Fahrzeuges dienen, benötigen. Zusatzeinrichtungen können beispielsweise ein Lichtsystem, ein Heizsystem und/oder eine Klimaanlage, ein Lüftungssystem und ein Informationssystem umfassen. Weiter ist bekannt, dass nicht nur schienengebundene Fahrzeuge, wie z.B. Straßenbahnen, sondern auch Straßenfahrzeuge mit elektrischer Energie betrieben werden können.

Fahrzeuge, insbesondere Elektrofahrzeuge, können in verschiedenen Weisen mit elektrischer Energie versorgt werden. Eine Möglichkeit ist, eine fahrzeugseitig installierte Batterie zu laden, wenn das Fahrzeug steht. Hierfür kann eine Kabelverbindung zum Fahrzeug hergestellt werden. Eine andere Möglichkeit ist es, Energie drahtlos zum Fahrzeug zu übertragen, wobei ein elektromagnetisches Feld genutzt wird, welches in mindestens einer Induktivität im Fahrzeug eine elektrische Spannung induziert. Der Begriff "Empfangsvorrichtung" oder "Pick-up" kann hierbei eine Vorrichtung bezeichnen, die eine solche Induktivität umfasst.

Die induktionsbasierte Übertragung von elektrischer Energie zum Fahrzeug bildet den Hintergrund dieser Erfindung. Eine fahrbahnseitige Leiteranordnung, die auch als Primärwindungsstruktur bezeichnet werden kann, erzeugt ein elektromagnetisches Feld zur Leistungsübertragung. Dieses Feld wird von einer fahrzeugseitig angeordneten Leiteranordnung, die auch als Sekundärwindungsstruktur oder Sekundärspule bezeichnet werden kann, im Fahrzeug empfangen, wobei das elektromagnetische Feld eine elektrische Spannung durch Induktion erzeugt. Die derart übertragene Energie kann zum Antrieb des Fahrzeugs und/oder für andere Anwendungen, wie z.B. die Versorgung von Zusatzeinrichtungen des Fahrzeugs, dienen. Das Fahrzeug kann z.B. ein Fahrzeug mit einem elektrisch betreibbaren Antriebsmotor sein. Allerdings kann das Fahrzeug auch ein sogenanntes hybrides Antriebssystem umfassen, z.B. ein System, welches mit elektrischer Energie oder anderer Energie, die z.B. durch die Nutzung von Kraftstoff, wie z.B. Gas, Diesel oder Benzin oder Wasserstoff, betrieben werden kann.

Es besteht ein Bedürfnis zur Integration einer Empfangsvorrichtung mit einer Sekundärwindungsstruktur in existierende Fahrzeuge, insbesondere Automobile. Ein Gewicht der Empfangsvorrichtung sollte gering sein, um ein Gesamtgewicht des Fahrzeugs so wenig wie möglich zu beeinträchtigen. Weiterhin sollten die Konstruktion der Empfangsvorrichtung stabil und die Montage der Empfangsvorrichtung einfach durchführbar sein. Weiter sollten existierende Bauräume, insbesondere im Bereich einer Unterseite eines Fahrzeugs, genutzt werden.

Typischerweise wird das magnetische Feld (als Teil eines elektromagnetischen Wechselfeldes) durch eine Vorrichtung erzeugt, die unter der Fahrzeugunterseite angeordnet ist. Darum wird eine Empfangsvorrichtung typischerweise an der Unterseite des Fahrzeugs montiert, um das magnetische Feld von unten zu empfangen. Allerdings ist es auch möglich, die Empfangsvorrichtung in weitere Richtungen, wie z.B. eine horizontale Richtung, zu orientieren, falls die Vorrichtung zum Erzeugen des elektromagnetischen Feldes in der entsprechenden Richtung angeordnet ist, z.B. an einer Wand. Generell weist die Empfangsvorrichtung eine Empfangsseite auf, wobei während des Betriebes das magnetische Feld von der Empfangsseite her in die Empfangsvorrichtung eintritt.

WO 2014/166963 A1 offenbart eine Empfangsvorrichtung zum Empfang eines magnetischen Feldes und zum Bereitstellen elektrischer Energie durch magnetische Induktion, wobei die Empfangsvorrichtung zumindest eine Spule einer elektrischen Leitung umfasst. Weiterhin induziert das magnetische Feld eine elektrische Spannung in der Spule während eines Betriebes. Weiterhin umfasst die Spule eine Induktivität, wobei die Empfangsvorrichtung und die Spule derart ausgebildet sind, dass das magnetische Feld von einer Empfangsseite her empfangen werden kann. Weiterhin umfasst die Empfangsvorrichtung ein Gehäuse, welches die zumindest eine Spule und weitere Komponenten der Empfangsvorrichtung umfasst.

WO 2015/150297 A2 offenbart eine Empfangsvorrichtung, insbesondere eine Empfangsvorrichtung für ein System zur induktiven Leistungsübertragung zu einem Fahrzeug, wobei die Empfangsvorrichtung ein Gehäuse umfasst. Weiterhin ist zumindest ein Medium in dem Gehäuse angeordnet, wobei das Medium einen thermischen Ausdehnungskoeffizienten aufweist, der kleiner als der thermische Ausdehnungskoeffizient von Luft ist.

Die EP 2 618 344 A1 offenbart einen Umformer, der zum drahtlosen Laden eines Fahrzeugs genutzt wird.

Die DE 10 2012 202 472 A1 offenbart eine Vorrichtung zur kontaktlosen Übertragung von Energie auf eine zu dieser korrespondierenden Vorrichtung.

Die WO 2014/166963 A1 offenbart eine Empfangsvorrichtung zum Empfangen eines elektromagnetischen Felds.

Die DE 31 07 455 A1 offenbart ein Gehäuse, bei dem ein Gehäuseteil mit einem umlaufenden Vorsprung in eine umlaufende Nut eines anderen Gehäuseteils ragt, in welche zur Abdichtung ein O-Ring vorgesehen ist.

Die WO 2015/150297 A2 offenbart eine Empfangsvorrichtung eines Systems zur induktiven Leistungsübertragung.

Die EP 1 391 640 A1 offenbart einen Dichtungsring, mit einem maßgeblich für die Formstabilität verantwortlichen ringförmigen Grundkörper, der an wenigstens einer Axialseite eine konzentrisch angeordnete Ringnut mit zwei sich radial gegenüberliegenden Nutflanken aufweist, in der ein aus gummielastischem Material bestehender Ringkörper gehalten ist, der einen axial über den Grundkörper vorstehenden Dichtwulst aufweist.

Zusätzlich zu einer Empfangswindungsstruktur (Sekundärwindungsstruktur) kann die Empfangsvorrichtung weitere elektrische und elektronische Komponenten umfassen. Beispielsweise kann die Empfangsvorrichtung einen Gleichrichter umfassen, wobei der Gleichrichter leistungselektronische Elemente umfassen kann. Weiter kann die Empfangsvorrichtung Regelungs- und Messelemente umfassen.

Zusätzlich zu der Empfangswindungsstruktur können auch diese weiteren Komponenten in dem Gehäuse der Empfangsvorrichtung angeordnet werden.

Während eines Betriebes des Fahrzeugs mit einer solchen Empfangsvorrichtung können große Temperaturänderungen der Temperatur im Gehäuse auftreten. Um einen zuverlässigen Betrieb der Empfangsvorrichtung, insbesondere der elektrischen und elektronischen Komponenten, zu ermöglichen, ist es wünschenswert, ein Innenvolumen des Gehäuses über den gesamten Temperaturbereich zuverlässig, gegen das Eindringen von Schmutz und/oder Wasser abzudichten.

Es stellt sich das technische Problem, eine Empfangsvorrichtung sowie ein Verfahren zur Herstellung einer Empfangsvorrichtung für ein System zur induktiven Leistungsübertragung zu schaffen, die einen zuverlässigen Betrieb der Empfangsvorrichtung über einen großen Temperaturbereich ermöglichen.

Die Lösung des technischen Problems ergibt sich durch die Gegenstände mit den Merkmalen der Ansprüche 1 und 11. Weitere vorteilhafte Ausgestaltungen der Erfindung ergeben sich aus den Unteransprüchen.

Vorgeschlagen wird eine Empfangsvorrichtung für ein System zur induktiven Leistungsübertragung. Das System kann insbesondere zur induktiven Leistungsübertragung zu einem Fahrzeug, insbesondere einem Automobil, dienen. Die Empfangsvorrichtung umfasst ein Gehäuse, wobei das Gehäuse als Gehäuseteile einen Deckelteil und einen Bodenteil umfasst.

Das Gehäuse kann an einem Fahrzeug montiert werden. Insbesondere kann das Gehäuse an einem Fahrzeugrahmen, weiter insbesondere an einem Vorderachsträger, des Fahrzeugs montiert werden. Weiter kann das Gehäuse an oder im Bereich einer Unterseite des Fahrzeugs am Fahrzeug montiert werden. Das Gehäuse kann mindestens ein Befestigungsmittel aufweisen, um das Gehäuse am Fahrzeug zu montieren. Es ist beispielsweise möglich, dass das Deckelteil und/oder das Bodenteil zumindest eine, vorzugsweise mehrere, Öffnung/en zur Aufnahme einer Schraube aufweisen. Dies erlaubt das Verschrauben des Gehäuses mit dem Fahrzeug.

In einem montierten Zustand, in dem die Empfangsvorrichtung an dem Fahrzeug montiert ist, ist das Deckelteil über dem Bodenteil angeordnet. Nachfolgend kann auf das folgende Koordinatensystem der Empfangsvorrichtung Bezug genommen werden.

Eine Vertikalachse der Empfangsvorrichtung kann senkrecht zu einer Oberseite des Deckelteils und einer Unterseite des Bodenteils orientiert sein. Eine Längsachse der Empfangsvorrichtung kann parallel zu einer Längsrichtung des Gehäuses orientiert sein. Eine Querachse der Empfangsvorrichtung kann parallel zu einer Querachse des Gehäuses orientiert sein. Hierbei kann eine Breite des Gehäuses entlang der lateralen Achse kleiner als eine Länge entlang der Längsachse sein. Im montierten Zustand kann die Vertikalachse parallel zu einer Vertikalachse oder einer Gierachse des Fahrzeugs orientiert sein. Weiter kann die Querachse der Empfangsvorrichtung parallel zu einer Querachse oder Nickachse des Fahrzeuges orientiert sein. Weiter kann die Längsachse der Empfangsvorrichtung parallel zu einer Längsachse oder Rollachse des Fahrzeugs orientiert sein. Die Achsen können weiter senkrecht zueinander orientiert sein.

Weiter weist das Gehäuse ein Innenvolumen zur Aufnahme mindestens einer Windungsstruktur, insbesondere der Sekundärwindungsstruktur, auf. In einem geschlossenen Zustand, in dem das Deckelteil und das Bodenteil aneinander befestigt sind, kann das Innenvolumen von dem Deckel- und Bodenteil umfasst werden. Das Innenvolumen wird somit von dem Deckel- und Bodenteil begrenzt.

Das Innenvolumen kann neben der Aufnahme der Windungsstruktur auch zur Aufnahme weiterer Komponenten der Empfangsvorrichtung, insbesondere elektrischer und elektronischer Komponenten, dienen. Diese können beispielsweise auf einer, zwei oder mehreren Leiterplatten angeordnet sein, wobei die Leiterplatten ebenfalls im Innenvolumen angeordnet werden können. Weiter kann in dem Innenvolumen ein magnetisch leitfähiges Element, insbesondere ein Ferritelement, angeordnet werden. Die Empfangsvorrichtung kann diese weiteren Komponenten, Leiterplatten und/oder das magnetisch leitfähige Element umfassen.
Die Windungsstruktur kann eine erste und mindestens eine weiteren Teilwindung umfassen. Die erste und die zumindest eine weitere Teilwindung sind elektrisch verbunden.

Die Windungsstruktur empfängt das elektromagnetische Feld und stellt eine induzierte Ausgangsspannung bereit. In diesem Fall empfängt die erste Teilwindung einen ersten Anteil des elektromagnetischen Felds und die zweite Teilwindung einen weiteren Anteil des elektromagnetischen Felds, wenn die Windungsstruktur dem elektromagnetischen Feld ausgesetzt ist. Jede Teilwindung kann einen Pol des elektromagnetischen Felds, das durch den induzierten Strom erzeugt wird, bereitstellen.

Eine Teilwindung kann einen oder mehrere Abschnitt(e) einer Phasenleitung der Windungsstruktur umfassen. Die Windungsstruktur kann eine oder mehrere Phasenleitung(en) zum Leiten eines elektrischen Stroms umfassen. Eine Teilwindung kann eine vorbestimmte Fläche umfassen. Eine Teilwindung kann eine Spule, beispielsweise mit einer vorbestimmten Windungszahl, aufweisen oder ausbilden.

Die zumindest eine Phasenleitung kann derart ausgebildet sein, dass ein Verlauf der Phasenleitung eine gerade oder eine ungerade Anzahl von Teilwindungen ausgebildet, die benachbart zueinander angeordnet sind. In diesem Fall bezeichnet eine Teilwindung eine, bevorzugt geschlossene, Leiterschleife die die vorbestimmte Fläche umfasst. Die Leiterschleife kann eine oder mehrere Windung(en) der entsprechenden Teilwindung umfassen oder ausbilden.

Benachbart zueinander kann bedeuten, dass zentralen Achsen der Teilwindungen, insbesondere Symmetrieachsen, entlang einer geraden Linie beabstandet voneinander angeordnet sind, insbesondere mit einem vorbestimmten Abstand. Die gerade Linie kann parallel zur longitudinalen Richtung der Empfangseinrichtung sein. Dies kann bedeuten, dass die Phasenleitung der Windungsstruktur sich entlang einer Erstreckungsrichtung erstrecken kann, wobei die vorbestimmte Anzahl von Teilwindungen entlang der Erstreckungsrichtung bereitgestellt wird.

Benachbarte Teilwindungen können entgegengesetzt orientiert sein. In diesem Kontext kann entgegengesetzt bedeuten, dass ein Stromfluss in der ersten Teilwindung im Uhrzeigersinn orientiert ist, wobei der Stromfluss in der benachbarten Teilwindung entgegen dem Uhrzeigersinn orientiert ist. Der Uhrzeigersinn kann mit Bezug auf parallele zentralen Achsen definiert sein, die in die gleiche Richtung orientiert sind. Wenn ein Strom in den Teilwindungen fließt, können benachbarte Teilwindungen ein magnetisches Feld mit der gleichen Stärke, jedoch entgegengesetzter Orientierung erzeugen.

Bevorzugt hat die Windungsstruktur die Form einer Acht. Dies kann bedeuten, dass ein Verlauf der mindestens einen Phasenleitung ein achtförmiger Verlauf ist. In diesem Fall kann die Phasenleitung zwei, z.B. kreis- oder rechteckförmige, Teilwindungen aufweisen, die benachbart zueinander entlang der vorhergehend erläuterten Erstreckungsrichtung angeordnet sind.

Bevorzugt umfasst die Windungsstruktur eine erste und eine zweite Teilwindung. In diesem Fall kann die Windungsstruktur auch als Doppel-D-Windungsstruktur bezeichnet werden.

Weiter weist eines der Gehäuseteile mindestens einen Steg und das verbleibende Gehäuseteil mindestens eine Nut zur Aufnahme des Stegs auf. Eine Nut und ein Steg können als korrespondierend bezeichnet werden, wenn die Nut zur Aufnahme des Stegs dient. In einem aufgenommenen Zustand erstreckt sich zumindest ein Teil des Stegs in zumindest einen Teil der Nut.

Es ist auch vorstellbar, dass ein Gehäuseteil sowohl mindestens einen Steg als auch mindestens eine Nut aufweist, insbesondere in verschiedenen Abschnitten des Gehäuseteils. Das verbleibende Gehäuseteil kann eine zum Steg korrespondierende Nut und/oder einen zur Nut korrespondierenden Steg aufweisen.

Es ist aber auch möglich, dass eines der Gehäuseteile mindestens eine Nut oder mindestens einen Abschnitt einer Nut aufweist, wobei das verbleibende Gehäuseteil keinen korrespondierenden Steg oder Stegabschnitt aufweist.

Vorzugsweise weist das Deckelteil die Nut und das Bodenteil den Steg auf. Hierbei kann der Steg von einer Oberfläche, insbesondere einer Oberseite des Bodenteils, nach oben abstehen. Vorzugsweise ist eine Tiefe der Nut größer als eine Höhe des Steges. Eine Kontur der Nut kann hierbei gleich der Kontur des Steges sein.

Der Steg und die Nut können, insbesondere im befestigten Zustand, eine Nut-Feder-Verbindung ausbilden. Diese Nut-Feder-Verbindung kann Teil der form- und/oder kraftschlüssigen Verbindung sein. Somit kann die Nut oder zumindest ein Abschnitt davon zur Aufnahme des Stegs oder mindestens eines Abschnitts davon ausgebildet sein, insbesondere im geschlossenen Zustand des Gehäuses.

Weiter sind der Steg und die Nut jeweils zwischen dem Innenvolumen und einem Außenvolumen angeordnet. Das Außenvolumen kann das Volumen außerhalb des Gehäuses im geschlossenen Zustand des Gehäuses bezeichnen. Insbesondere kann also der Steg und die Nut zwischen einem inneren Randabschnitt eines Gehäuseteils, der das Innenvolumen begrenzt, und einem äußeren Randabschnitt des Gehäuseteils, der an das Außenvolumen angrenzt, angeordnet sein.

Vorzugsweise verlaufen der Steg und/oder die Nut um zumindest einen Teil des Innenvolumens, vorzugsweise um das gesamte Innenvolumen, herum. Insbesondere können der Steg und/oder die Nut einen geschlossenen Verlauf um das Innenvolumen herum aufweisen.

Dass der Steg und die Nut um zumindest einen Teil des Innenvolumens herum verlaufen, kann beispielsweise bedeuten, dass die Nut und der Steg in einer Projektionsfläche, die beispielsweise senkrecht zur Vertikalachse der Empfangsvorrichtung orientiert sein kann, zwischen dem Innenvolumen und dem Außenvolumen angeordnet ist.

Dass der Steg und die Nut um das gesamte Innenvolumen herum verlaufen, kann beispielsweise bedeuten, dass das Innenvolumen in einer Projektionsfläche, die beispielsweise senkrecht zur Vertikalachse der Empfangsvorrichtung orientiert sein kann, vollständig von der Nut und dem Steg umfasst wird.

Es ist jedoch nicht zwingend, dass der Steg und/oder die Nut einen geschlossenen Verlauf um das Innenvolumen herum aufweisen. Es ist insbesondere vorstellbar, dass ein Verlauf des Stegs und/oder der Nut um das Innenvolumen herum kein geschlossener Verlauf ist.

Beispielsweise kann eines der Gehäuseteile mehrere Stege und das verbleibende Gehäuseteil eine oder mehrere Nut(en) zur Aufnahme der Stege aufweisen. Weist eines der Gehäuseteile nur eine Nut zur Aufnahme mehrere Stege auf, so kann diese Nut einen geschlossenen Verlauf um das Innenvolumen herum aufweisen. Weist eines der Gehäuseteile mehrere Nuten zur Aufnahme mehrere Stege auf, so können diese Nuten keinen geschlossenen Verlauf um das Innenvolumen herum aufweisen oder ausbilden. Entlang eines Verlaufs einer Nut kann sich eine Tiefe der Nut verändern. Mit anderen Worten können verschiedene Abschnitte der Nut verschiedene Tiefen aufweisen. Ein Wert der Tiefe ist hierbei jedoch von Null verschieden.

Weiter kann sich entlang eines Verlaufs eines Stegs eine Höhe des Stegs verändern. Mit anderen Worten können verschiedene Abschnitte des Stegs verschiedene Höhen aufweisen. Ein Wert der Tiefe ist hierbei jedoch von Null verschieden.

Weiter ist es möglich, dass ein Gehäuseteil mindestens eine Nut und mindestens einen Steg aufweist oder ausbildet. Weiter ist es möglich, dass der Steg entlang seines Verlaufs seine Höhe ändert und in einen nut- und stegfreien Bereich oder in eine Nut übergeht. Nach dem Übergang in den nut- und stegfreien Bereich und/oder in eine Nut kann dieser/diese entlang des Verlaufs wieder in einen Steg übergehen. Auch ist es möglich, dass eine Nut entlang ihres Verlaufs ihre Tiefe ändert und in einen nut- und stegfreien Bereich oder in einen Steg übergeht. Nach dem Übergang in den nut- und stegfreien Bereich und/oder in einen Steg kann dieser entlang des Verlaufs wieder in eine Nut übergehen.

Weiter umfasst die Empfangsvorrichtung mindestens ein Dichtelement, wobei zumindest ein Abschnitt des mindestens einen Stegs und zumindest ein Abschnitt des Dichtelements in zumindest einem Abschnitt der mindestens einen Nut angeordnet sind, insbesondere im geschlossenen Zustand des Gehäuses. Somit kann im geschlossenen Zustand sowohl ein Teil des Steges als auch zumindest ein Abschnitt des Dichtelements in zumindest einem Abschnitt der Nut angeordnet sein. Weiter kann, insbesondere in einem weiteren Abschnitt, nur ein Abschnitt des Dichtelements, aber kein Abschnitt eines Stegs, in der Nut angeordnet sein.

Insbesondere kann die Empfangsvorrichtung genau ein Dichtelement aufweisen, wobei zumindest ein Abschnitt des Stegs und zumindest ein Abschnitt des mindestens einen Dichtelements in zumindest einem Abschnitt der mindestens einen Nut angeordnet ist, insbesondere im geschlossenen Zustand des Gehäuses. Auch kann das Dichtelement vollständig in der Nut angeordnet sein, insbesondere im geschlossenen Zustand.

Das Dichtelement kann hierbei ebenfalls einen geschlossenen Verlauf aufweisen. Weiter kann das Dichtelement einstückig oder einteilig ausgebildet sein. Das Dichtelement oder zumindest ein Abschnitt davon ist hierbei in der Nut oder einem Abschnitt davon anordenbar und kann bei der Befestigung des Deckelteils an dem Bodenteil in der Nut von dem Deckel- und Bodenteil eingeschlossen werden. Insbesondere kann das Dichtelement durch den Steg oder einen Abschnitt davon im befestigten Zustand durch den Steg in die Nut eingepresst werden.

Im geschlossenen Zustand des Gehäuses, der auch als zusammengebauter Zustand bezeichnet werden kann, kann der zumindest eine Abschnitt des Stegs und der zumindest eine Abschnitt des Dichtelements derart in zumindest einem Abschnitt der Nut angeordnet sein, dass das Innenvolumen in diesem Abschnitt gegenüber dem Außenvolumen abgedichtet ist.

Das Dichtelement und dessen Anordnung ermöglicht somit eine möglichst gute, insbesondere auch vollständige, Abdichtung des Innenvolumens, insbesondere zum Verhindern des Eindringens von Feuchtigkeit und Schmutzpartikeln.

Das Deckelteil kann beispielsweise aus Aluminium oder aus einer Aluminiumlegierung bestehen. Das Bodenteil kann aus Kunststoff, insbesondere aus glasfaserverstärktem Kunststoff, bestehen. Im geschlossenen Zustand kann das Deckelteil form- und/oder kraftschlüssig an dem Bodenteil befestigt sein.

Hierdurch ergibt sich in vorteilhafter Weise eine zuverlässige Abdichtung des Innenvolumens und somit ein zuverlässiger Betrieb der Empfangsvorrichtung, insbesondere in einem großen Temperaturbereich.

In einer weiteren Ausführungsform weist mindestens eines der Gehäuseteile mindestens ein Befestigungsmittel zur Befestigung der Gehäuseteile aneinander auf, wobei das mindestens eine Befestigungsmittel außerhalb des abgedichteten Innenvolumens angeordnet ist. Ein Befestigungsmittel bezeichnet hierbei ein Element oder ein Bauteil, welches zur Befestigung des Deckelteils an dem Bodenteil, insbesondere also zur Herstellung einer mechanischen Verbindung, dient.

Dass das mindestens eine Befestigungsmittel außerhalb des abgedichteten Innenvolumens angeordnet ist, kann bedeuten, dass das Befestigungsmittel in der gemeinsamen Projektionsebene außerhalb des Verlaufs des Steges und der Nut sowie des von diesem Verlauf zumindest teilweise oder vollständig umfassten Innenvolumens angeordnet ist. Der Verlauf kann insbesondere ein Verlauf entlang der mindestens einen oder entlang des mindestens einen Stegs sein. Bei einem Gehäuseteil mit mehreren Nuten, mindestens einer Nut und mindestens einem Steg oder mit mehreren Stegen kann der Verlauf die voneinander verschiedene Nuten/Stege verbinden und um das Innenvolumen herum verlaufen.

Vorzugsweise weist das Bodenteil als Befestigungsmittel eine Durchgangsöffnung und das Deckelteil als Befestigungsmittel einen Gewindeabschnitt als Befestigungsmittel auf, die ein Verschrauben der Teile ermöglichen. Somit können die Durchgangsöffnung, der Gewindeabschnitt und auch eine zum Verschrauben benötigte Schraube außerhalb des abgedichteten Innenvolumens angeordnet sein.

Hierdurch wird in vorteilhafter Weise die Gefahr einer Undichtigkeit aufgrund der Befestigung verringert bzw. ausgeräumt.

In einer weiteren Ausführungsform weist zumindest eines der Gehäuseteile ein erstes Membranelement auf. Vorzugsweise weist das Deckelteil das erste Membranelement auf. Mit anderen Worten kann das erste Membranelement Teil des Deckelteils sein. Das Membranelement kann einen Druckausgleich zwischen dem Innenvolumen und einem außerhalb des abgedichteten Innenvolumens angeordneten Außenvolumen ermöglichen. Beispielsweise kann das erste Membranelement in einem Bodenabschnitt des Deckelteils angeordnet sein, wobei das erste Membranelement zwischen dem Innenvolumen und dem Außenvolumen angeordnet ist. Das erste Membranelement kann einem Ausgleich zwischen dem Druck im Innenvolumen und dem Außendruck oder einer Reduzierung des entsprechenden Druckunterschieds dienen.

In einer bevorzugten Ausführungsform ist das erste Membranelement dampfdurchlässig. Weiter kann das erste Membranelement semipermeabel sein.

Das erste Membranelement kann insbesondere derart ausgebildet sein, dass Dampf, insbesondere Wasserdampf, aus dem Innenvolumen in das Außenvolumen, nicht jedoch umgekehrt, gelangen kann.

Aufgrund von Temperaturschwankungen der Temperatur im Innenvolumen ist es möglich, dass in der Luft des Innenvolumens enthaltene Wassermoleküle kondensieren. Eine derartige Kondensation kann jedoch einen Betrieb der Empfangsvorrichtung, insbesondere der elektrischen und elektronischen Komponenten, beeinträchtigen. Durch das erste Membranelement kann in vorteilhafter Weise erreicht werden, dass Wassermoleküle aus dem Innenvolumen in das Außenvolumen gelangen, wobei jedoch keine Wassermoleküle, beispielsweise durch Spritzwasser, vom Außenvolumen in das Innenvolumen gelangen können.

Weiter kann das erste Membranelement in einem Bereich des Gehäuses, insbesondere des Deckelteils, angeordnet sein, in den eine große Menge thermischer Energie beim Betrieb der Empfangsvorrichtung übertragen wird.

Es ist beispielsweise möglich, dass das erste Membranelement entlang der Vertikalachse der Empfangsvorrichtung im montierten Zustand über leistungselektronischen Komponenten, beispielsweise über MOSFET oder über Dioden einer Gleichrichterschaltung, angeordnet ist. Weiter kann das erste Membranelement an einem Ende oder entlang eines Wärmeübertragungsmittels angeordnet sein, welches eine thermische Verbindung zwischen dem ersten Membranelement oder einem Bereich unter dem ersten Membranelement und einem Bereich mit hohem thermischen Energieeintrag, beispielsweise einem Anordnungsbereich der elektrischen oder elektronischen Komponenten, verbindet.

Somit kann die Empfangsvorrichtung mindestens ein Wärmeübertragungsmittel, beispielsweise ein Wärmerohr, umfassen, über welches das erste Membranelement oder der Bereich unter dem ersten Membranelement thermisch mit einem vorbestimmten Bereich im Innenvolumen, insbesondere einem Anordnungsbereich für eine Leiterplatte, verbunden ist.

Hierdurch kann in vorteilhafter Weise ein ausreichendes Dampfdruckgefälle zwischen dem Innenvolumen und dem Außenvolumen erzeugt werden, was wiederum den Transport von Wassermolekülen aus dem Innenvolumen heraus vereinfacht und beschleunigt.

In einer weiteren Ausführungsform umfasst zumindest eines der Gehäuseteile mindestens ein weiteres Membranelement. Vorzugsweise umfasst das Deckelteil auch das mindestens eine weitere Membranelement. Auch das weitere Membranelement kann einem Ausgleich zwischen dem Druck im Innenvolumen und dem Außendruck oder einer Reduzierung des entsprechenden Druckunterschiedes dienen.

In einer bevorzugten Ausführungsform ist das mindestens eine weitere Membranelement elastisch und dampfundurchlässig.

Aufgrund der starken Temperaturänderungen der Innentemperatur kann sich auch der Druck im Innenvolumen stark verändern. Dies ist insbesondere auch durch die in der Regel mechanisch starre Ausbildung des Deckel- und Bodenteils bedingt, die keine großen druckänderungsbedingten Volumenänderungen des Innenvolumens zulassen. Um keinen unerwünschten Unterdruck im Innenvolumen zu erzeugen, ist das weitere Membranelement elastisch. Auch das weitere Membranelement kann zwischen dem Innenvolumen und dem Außenvolumen angeordnet sein. Weiter kann das weitere Membranelement in einem Bodenteil des Deckelteils angeordnet sein.
Ein unzulässiger Unterdruck im Innenvolumen kann insbesondere dann entstehen, wenn der Transport von Wassermolekülen durch das erste Membranelement aus dem Innenvolumen heraus nicht möglich ist, beispielsweise wenn das erste Membranelement mit Wasser bedeckt ist. Dies kann beispielsweise der Fall sein, wenn das Fahrzeug, insbesondere das Gehäuse, durch eine Pfütze fährt.

Ist eine Temperatur des Gehäuses, insbesondere des Innenvolumens, höher als die Außentemperatur, z.B. des Wassers der Pfütze, und ist das erste Membranelement blockiert, so kann das Abkühlen des Innenvolumens aufgrund des Temperaturunterschieds zu Erzeugung eines Unterdrucks im Innenvolumen führen.

Aufgrund der Elastizität des zweiten Membranelements kann sich dann das Volumen des Innenvolumens derart ändern, dass ein Unterdruck im Innenvolumen geringer als ein maximal zulässiger Unterdruck ist.

Insbesondere kann das weitere Membranelement derart elastisch ausgebildet sein, dass es sich bei einem Unterschreiten eines vorbestimmten Druckes im Innenvolumen nach innen wölbt und somit das Innenvolumen verkleinert. Hierbei kann davon ausgegangen werden, dass im Außenvolumen ein Druck aus einem vorbestimmten Druckbereich herrscht, insbesondere atmosphärischer Druck.

Das weitere Membranelement kann alternativ relativ zum Gehäuse beweglich an diesem befestigt sein. In diesem Fall kann das weitere Membranelement auch aus einem mechanisch stabilen Material, beispielsweise Kunststoff, bestehen.

Fällt der Druck im Innenvolumen unter den Druck im Außenvolumen, so kann sich das weitere Membranelement nach innen wölben und/oder sich hin zum Innenvolumen bewegen. Hierdurch wird das Innenvolumen verkleinert, was wiederum den entstehenden Unterdruck begrenzt.

In einer weiteren Ausführungsform ist ein äußeres Ende eines Membranelements, insbesondere ein äußeres Ende des ersten Membranelements, in einer Rille an einer Außenseite des Gehäuses angeordnet. Das äußere Ende des Membranelements kann hierbei das mit dem Außenvolumen in Kontakt stehende Ende des Membranelements bezeichnen. Insbesondere kann das äußere Ende am Ende der Rille angeordnet sein. Die Rille kann gegenüber der Außenseite geneigt sein, um ein Abfließen von Wasser von dem Membranelement zu ermöglichen.

Hierdurch ergibt sich in vorteilhafter Weise, dass das aus dem Innenvolumen durch das Membranelement nach außen transportierte Wasser einfach, zuverlässig und schnell von dem Membranelement abtransportiert werden kann und somit dessen Funktionsfähigkeit gewährleistet ist.

Erfindungsgemäß umfasst die Empfangsvorrichtung mindestens ein Signalverbindungselement. Das Signalverbindungselement kann zur Herstellung einer signaltechnischen Verbindung von mindestens einer im Innenvolumen angeordneten Komponente der Empfangsvorrichtung und einer externen Einrichtung, beispielsweise einem fahrzeugseitig angeordneten Kommunikationssystem, dienen. Das Signalverbindungselement kann insbesondere als Steckverbindungselement, z.B. als Stecker oder Hülse ausgebildet sein. Das Signalverbindungselement erstreckt sich aus dem Innenvolumen in das Außenvolumen, wobei sich das Signalverbindungsmittel durch das mindestens eine Dichtelement hindurcherstreckt. Das Dichtelement kann in diesem Fall eine Durchgangsöffnung aufweisen, durch die sich das Signalverbindungsmittel hindurch erstreckt. Die Durchgangsöffnung kann insbesondere als Langloch ausgebildet sein. Hierdurch wird in vorteilhafter Weise die Herstellung einer signaltechnischen Verbindung zwischen dem Fahrzeug und der Empfangsvorrichtung ermöglicht, wobei die Gefahr des Eindringens von Schmutz und Feuchtigkeit minimiert wird.

Das Signalverbindungselement kann hierbei mindestens eine Nut zur Aufnahme des Dichtelements aufweisen oder ausbilden. Insbesondere kann das Signalverbindungselement eine Nut zur Aufnahme von Abschnitten des Dichtelements aufweisen, die die Durchgangsöffnung umschließen.

Die Höhe eines Stegs und/oder die Tiefe einer Nut kann in einem Signalverbindungselement-Aufnahmebereich des Bodenteils und des Deckelteils von einer Höhe bzw. Tiefe außerhalb des Signalverbindungselement-Aufnahmebereich verschieden sein. Ein Signalverbindungselement-Aufnahmebereich kann hierbei einen Bereich bezeichnen, in dem sich das Signalverbindungselement von dem Außenvolumen in das Innenvolumen erstreckt. In dem Signalverbindungselement-Aufnahmebereich kann das Dichtelement die Durchgangsöffnung aufweisen.

Im Signalverbindungselement-Aufnahmebereich kann das Bodenteil einen nut- und stegfreien Bereich aufweisen, in welchen der Steg des Bodenteils entlang seines Verlaufs übergeht, also einen Bereich mit einer Höhe von Null über der Oberfläche. Hierbei kann ein solcher nut- und stegfreier Bereich im Signalverbindungselement-Aufnahmebereich aus dem Bodenteil freigeschnitten sein, beispielsweise über Vertiefungen im Bereich der Oberseite des Bodenteils. Weiter ist es möglich, dass die Höhe des Stegs vor und/oder bei einem Übergang in den Signalverbindungselement-Aufnahmebereich abnimmt und bei und/oder nach einem Übergang aus dem Signalverbindungselement-Aufnahmebereich zunimmt.

Im Signalverbindungselement-Aufnahmebereich kann das Deckelteil einen nut- und stegfreien Bereich oder einen Steg aufweisen, in welchen die Nut des Deckelteils entlang ihres Verlaufs übergeht. Es ist es möglich, dass die Tiefe vor und/oder bei einem Übergang in den Signalverbindungselement-Aufnahmebereich abnimmt und bei und/oder nach einem Übergang aus dem Signalverbindungselement-Aufnahmebereich zunimmt.

Es ist selbstverständlich auch vorstellbar, dass die Empfangsvorrichtung mindestens ein Signalverbindungselement umfasst, welches sich aus dem Innenvolumen in das Außenvolumen erstreckt, wobei sich das Signalverbindungsmittel nicht durch ein Dichtelement hindurch erstreckt. Beispielsweise kann sich das Signalverbindungsmittel aus einem Abschnitt des Innenvolumens in das Außenvolumen erstrecken, wobei zwischen diesem Abschnitt des Innenvolumens und dem Außenvolumen kein Dichtelement, insbesondere auch keine Nut und/oder kein Steg, angeordnet ist/sind.

In einer weiteren Ausführungsform weisen der mindestens eine Steg und die mindestens eine Nut, insbesondere korrespondierende Stege und Nuten, jeweils mindestens einen konkaven Abschnitt auf. Der konkave Abschnitt kann hierbei entlang des Verlaufs des Steges und der Nut ausgebildet sein. Mit anderen Worten können der Steg und die Nut jeweils mindestens einen hin zum Innenvolumen gekrümmten Abschnitt aufweisen. Hierdurch kann, vom Außenvolumen her gesehen, eine Ausnehmung oder Vertiefung entlang des Verlaufs des Steges und der Nut bereitgestellt werden. In dieser Ausnehmung, die der von dem konkaven Abschnitt umfasste Bereich sein kann, kann insbesondere das vorhergehend erläuterte Befestigungsmittel oder ein Teil oder Abschnitt davon angeordnet sein. Hierdurch wird in vorteilhafter Weise ein Bauraum der erfindungsgemäßen Empfangsvorrichtung reduziert.

In einer weiteren Ausführungsform weist das mindestens eine Dichtelement an einer äußeren Oberfläche Erhebungen auf. Diese Erhebungen können einer Zentrierung des Dichtelements in der Nut dienen. Die Erhebungen können insbesondere in Abschnitten des Dichtelements angeordnet sein, die in gekrümmten Abschnitten der Nut angeordnet werden. Somit können die Erhebungen insbesondere an gekrümmten Abschnitten des Dichtelements angeordnet sein. Es ist auch möglich, dass eine räumliche Dichte von Erhebungen in gekrümmten Abschnitten des Dichtelements größer ist als in ungekrümmten Abschnitten.

Weiter kann die Erhebung seitlich von dem Dichtelement abstehen. Dies kann bedeuten, dass eine Erhebung hin zu einer Seitenwand der Nut absteht, wenn das Dichtelement in der Nut angeordnet ist. Das Dichtelement kann Erhebungen aufweisen, die auf gegenüberliegenden Seiten seitlich von dem Dichtelement abstehen. Entlang eines Verlaufs des Dichtelements können solche Erhebungen alternierend an einer ersten Seite und an einer der ersten Seite gegenüberliegenden Seite angeordnet sein, vorzugsweise in ungekrümmten Abschnitten des Dichtelements im eingesetzten Zustand. Alternativ können entlang des Verlaufs solche Erhebungen im gleichen Teilabschnitt des Dichtelements angeordnet sein, vorzugsweise in gekrümmten Abschnitten des Dichtelements im eingesetzten Zustand. Hierdurch wird in vorteilhafter Weise ein Verkippen des Dichtelements verhindert, wenn es in die Nut eingesetzt ist (eingesetzter Zustand). Selbstverständlich können solche Erhebungen, die auf gegenüberliegenden Seiten des Dichtelements seitlich von diesem abstehen, auch entlang des gesamten Verlaufs des Dichtelements alternierend oder in gleichen Teilabschnitten angeordnet sein.

Hierdurch ergibt sich in vorteilhafter Weise eine einfache Zentrierung des Dichtelements, insbesondere in gekrümmten Abschnitten der Nut.

In einer weiteren Ausführungsform ist das mindestens eine Dichtelement in einem Temperaturbereich von -40°C bis +120°C elastisch. Hierdurch ergibt sich in vorteilhafter Weise eine zuverlässige Abdichtung des Innenvolumens in einem Temperaturbereich von sich im Betrieb einstellenden Innentemperaturen des Gehäuses.

Weiter vorgeschlagen wird ein Verfahren zur Herstellung einer Empfangsvorrichtung für ein System zur induktiven Leistungsübertragung, wobei als Gehäuseteile eines Gehäuses der Empfangsvorrichtung ein Bodenteil und ein Deckelteil bereitgestellt werden. Weiter weist eines der Gehäuseteile mindestens einen Steg und das verbleibende Gehäuseteil mindestens eine Nut zur Aufnahme des zumindest eines Abschnitts des Stegs auf. Weiter wird zumindest ein Abschnitt mindestens eines Dichtelements in zumindest einem Abschnitt der mindestens einen Nut angeordnet, wobei das Deckelteil mit dem Bodenteil derart verbunden wird, dass zumindest ein Abschnitt des Steges in zumindest einem Abschnitt der Nut angeordnet wird und das darin angeordnete Dichtelement einschließt. Weiter sind der mindestens eine Steg, die mindestens eine Nut und das mindestens eine Dichtelement zwischen einem (abgedichteten) Innenvolumen zur Aufnahme einer Windungsstruktur und einem Außenvolumen angeordnet. Insbesondere verlaufen der Steg, die Nut und das Dichtelement um das abgedichtete Innenvolumen herum. Erfindungsgemäss umfasst das Verfahren die Merkmale nach Anspruch 11.

Das Verfahren ist hierbei geeignet, eine Empfangsvorrichtung gemäß einer der in dieser Offenbarung beschriebenen Ausführungsformen herzustellen. Somit kann das Verfahren alle hierzu notwendigen Schritte umfassen.

Weiter beschrieben wird ein Fahrzeug, wobei das Fahrzeug eine Empfangsvorrichtung gemäß einer der in dieser Erfindung beschriebenen Ausführungsformen umfasst. Die Empfangsvorrichtung kann hierbei an dem Fahrzeug, insbesondere im Bereich einer Unterseite, befestigt sein.

Die Empfangsvorrichtung kann daten- und/oder signaltechnisch mit einem Kommunikationssystem des Fahrzeugs, beispielsweise einem Bussystem, verbunden werden. Weiter kann die Empfangsvorrichtung elektrisch mit einem elektrischen System des Fahrzeugs, insbesondere einem Traktionsnetz, verbunden werden. Somit kann der Empfangsvorrichtung bereitgestellte elektrische Energie, die induktionsbasiert bereitgestellt wird, an das Fahrzeug übertragen werden.
Die Erfindung wird anhand eines Ausführungsbeispiels näher erläutert. Die Figuren zeigen:
- Fig. 1: einen schematischen Querschnitt durch eine erfindungsgemäße Empfangsvorrichtung,
- Fig. 2: einen schematischen Querschnitt durch ein Deckelteil,
- Fig. 3: eine schematische Draufsicht auf ein Deckelteil,
- Fig. 4: eine schematische Unteransicht eines Deckelteils,
- Fig. 5: eine schematische Draufsicht auf ein Bodenteil und
- Fig. 6: einen schematischen Längsschnitt durch ein Bodenteil,
- Fig. 7: eine detaillierte Unteransicht eines Deckelteils,
- Fig. 8: einen detaillierten Querschnitt durch ein geschlossenes Gehäuse und
- Fig. 9: eine schematische Seitenansicht eines Dichtelements,
- Fig. 10: eine detaillierte Unteransicht eines Deckelteils,
- Fig. 11: einen detaillierten Querschnitt durch ein geschlossenes Gehäuse,
- Fig. 12: eine perspektivische Ansicht eines Randabschnitts eines Bodenteils,
- Fig., 13: einen Querschnitt durch ein geschlossenes Gehäuse in einem Steckeraufnahmebereich.

Nachfolgend bezeichnen gleiche Bezugszeichen Elemente mit gleichen oder ähnlichen technischen Merkmalen.

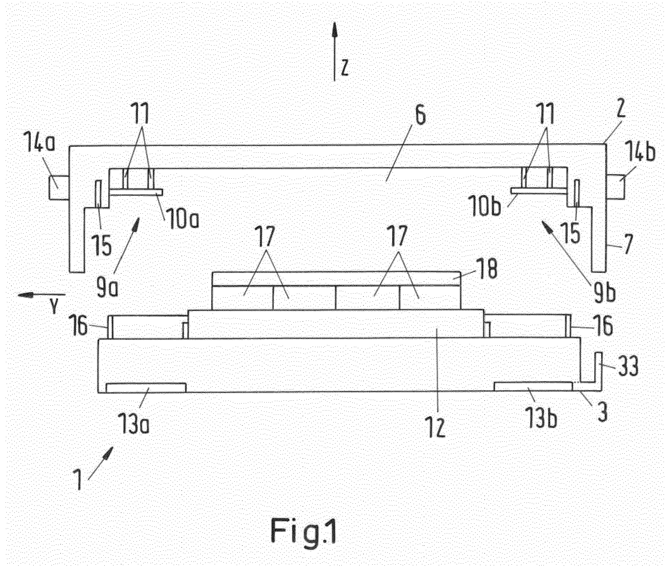

Fig. 1 zeigt einen schematischen Querschnitt durch eine Empfangsvorrichtung 1 eines Systems zur induktiven Energieübertragung. Die Empfangsvorrichtung 1 umfasst ein Gehäuse, wobei das Gehäuse einen Deckelteil 2 und einen Bodenteil 3 umfasst. Das Deckelteil 2 besteht aus Aluminium. Das Bodenteil 3 besteht aus Kunststoff, insbesondere aus glasfaserverstärktem Kunststoff.

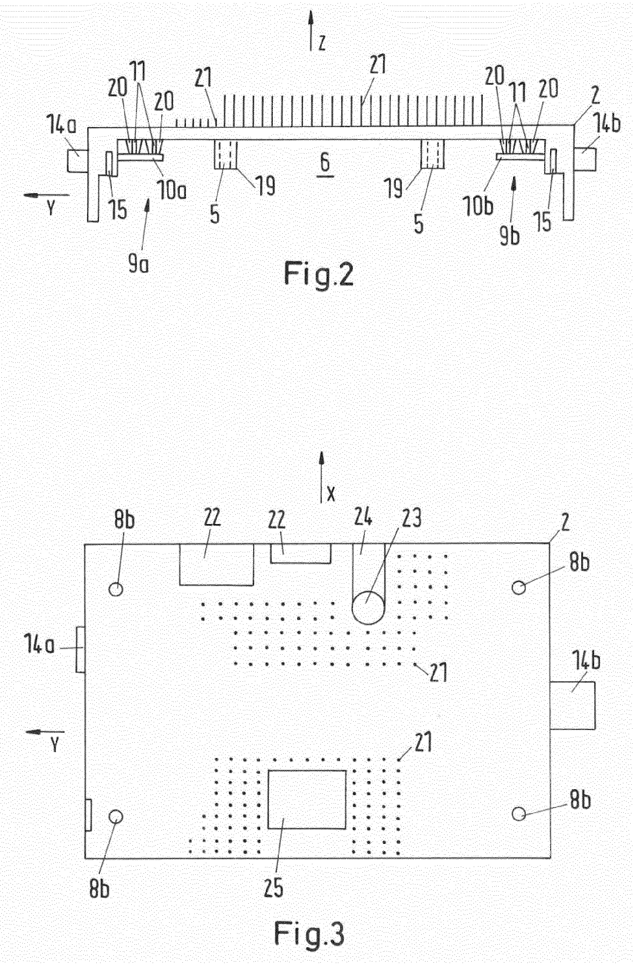

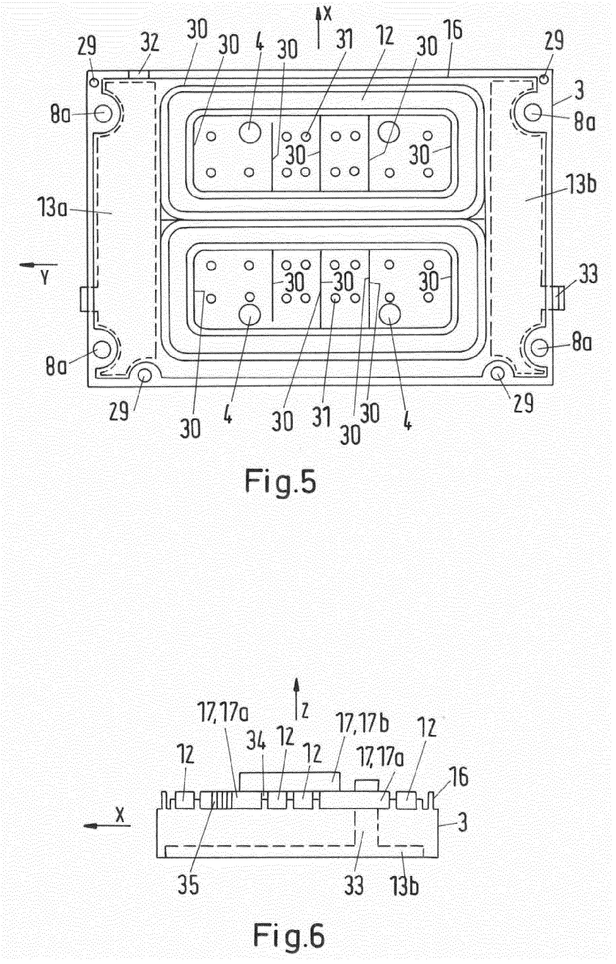

Das Bodenteil 3 kann an dem Deckelteil 2 befestigt werden, wodurch ein geschlossener Zustand des Gehäuses oder der Empfangsvorrichtung 1 hergestellt wird. Insbesondere kann das Bodenteil 3 mit dem Deckelteil 2 verschraubt werden. Um eine solche Schraubverbindung bereitzustellen, kann das Bodenteil 3 Durchgangslöcher 4, 29 (siehe Fig. 5) und das Deckelteil korrespondierende Gewindeabschnitte 5, 27 (siehe Fig. 2) aufweisen. Im geschlossenen Zustand ist das Bodenteil 3 vollständig in einem Innenvolumen 6 des Deckelteils 2 angeordnet. Seitenwände 7 des Deckelteils 2 umfassen im geschlossenen Zustand Seiten des Bodenteils 3.

Die Empfangsvorrichtung kann an einem Fahrzeug (nicht dargestellt) befestigt werden. Insbesondere kann die Empfangsvorrichtung 1 mit dem Fahrzeug verschraubt werden, insbesondere mit einem Vorderachsträger des Fahrzeugs. Um eine solche Schraubverbindung bereitzustellen, können das Bodenteil 3 und das Deckelteil 2 zueinander korrespondierende Durchgangslöcher 8a, 8b (siehe Fig. 5 und Fig. 3) aufweisen, wobei eine Schraube sich durch die korrespondierenden Durchgangslöcher 8a, 8b des Deckelteils 2 und des Bodenteils 3 im geschlossenen Zustand erstrecken kann. Weiter kann sich die Schraube in einen Gewindeabschnitts des Fahrzeugs erstrecken.

Weiter gezeigt ist, dass die Empfangsvorrichtung, insbesondere das Deckelteil 2, einen ersten Aufnahmebereich 9a und einen zweiten Aufnahmebereich 9b aufweist. Die Aufnahmebereiche 9a, 9b sind räumliche Teilbereiche eines Innenvolumens des Gehäuses im geschlossenen Zustand.

Im Folgenden kann das folgende Referenzkoordinatensystem verwendet werden. Eine Vertikalachse z kann orthogonal zu einer ebenen Oberfläche des Deckelteils 2 oder zu einer ebenen Bodenfläche des Bodenteils 3 orientiert sein. Ist die Empfangsvorrichtung 1 an dem Fahrzeug befestigt, was auch als montierter Zustand bezeichnet werden kann, so kann die Vertikalachse z parallel zu einer Gierachse des Fahrzeuges orientiert sein. Weiter kann eine vertikale Richtung parallel zu einer Hauptrichtung der induktiven Leistungsübertragung orientiert sein. Weiter ist eine laterale Achse y dargestellt, wobei die laterale Achse y senkrecht zur vertikalen Achse z orientiert ist. Im montierten Zustand kann die laterale Achse y parallel zu einer Nickachse des Fahrzeugs orientiert sein. Fig. 3 zeigt eine Längsachse x. Die Längsachse ist orthogonal zu der Vertikalachse und lateralen Achse z, y orientiert. Im montierten Zustand kann die Längsachse x parallel zu einer Rollachse des Fahrzeugs orientiert sein. Weiter sind eine Vertikalrichtung, eine laterale Richtung und eine Längsrichtung jeweils durch Richtungspfeile dargestellt.

Im befestigten Zustand der Empfangsvorrichtung 1 ist das Deckelteil 2 auf dem Bodenteil 3 montiert.

Weiter ist dargestellt, dass der erste Aufnahmebereich 9a an einem ersten lateralen Randbereich der Empfangsvorrichtung 1, insbesondere des Deckelteils 2, angeordnet ist. Der zweite Aufnahmebereich 9b ist in einem zweiten lateralen Randbereich angeordnet. Die Randbereiche sind hierbei an gegenüberliegenden Enden der Empfangsvorrichtung 1 mit Bezug auf die laterale Achse y angeordnet.

Ein Aufnahmebereich 9a, 9b kann z.B. durch eine Vertiefung in der Empfangsvorrichtung, insbesondere im Deckelteil 2, gebildet werden. Alternativ oder kumulativ kann ein Aufnahmebereich 9a, 9b durch Befestigungsmittel zur Befestigung einer Leiterplatte 10a, 10b an der Empfangsvorrichtung 1 festgelegt sein, insbesondere zur Befestigung an dem Deckelteil 2.

Weiter dargestellt ist, dass die Empfangsvorrichtung 1 eine erste Leiterplatte 10a und eine zweite Leiterplatte 10b umfasst. Die erste Leiterplatte 10a ist in dem ersten Aufnahmebereich 9a angeordnet. Weiter ist die erste Leiterplatte 10a an dem Deckelteil 2 befestigt. Weiter ist die zweite Leiterplatte 10b in dem zweiten Aufnahmebereich 9b angeordnet. Weiter ist die zweite Leiterplatte 10b an dem Deckelteil 2 befestigt.

Insbesondere können die Leiterplatten 10a, 10b mit dem Deckelteil 2 verschraubt sein. Um eine solche Schraubverbindung bereitzustellen, können sich Schrauben 11 durch Durchgangslöcher der Leiterplatten 10a, 10b (nicht dargestellt) in Gewindeabschnitte des Deckelteils 2 erstrecken. Die mechanische Verbindung zwischen den Leiterplatten 10a, 10b und dem Deckelteil 2 kann hierbei auch eine elektrische Verbindung zwischen den Leiterplatten 10a, 10b und dem Deckelteil 2 bereitstellen.

Es ist möglich, dass das Deckelteil 2 elektrisch mit einem Referenzpotential, beispielsweise einem Massepotential, des Fahrzeugs verbunden ist. In diesem Fall kann die elektrische Verbindung der Leiterplatten 10a, 10b mit dem Deckelteil 2 ebenfalls eine elektrische Verbindung der Leiterplatten 10a, 10b zum Referenzpotential bereitstellen. Die elektrische Verbindung zwischen dem Deckelteil 2 und dem Referenzpotential des Fahrzeugs kann hierbei durch die mechanische Verbindung zwischen der Empfangsvorrichtung und dem Fahrzeug, insbesondere durch die Schrauben zur Befestigung der Empfangsvorrichtung 1 an dem Fahrzeug, bereitgestellt werden.

Im geschlossenen Zustand des Gehäuses oder im montierten Zustand der Empfangsvorrichtung sind die Aufnahmebereiche 9a, 9b seitlich oder neben einer Windungsstruktur 12 (siehe Fig. 5) zum Empfang des elektromagnetischen Wechselfeldes zur Leistungsübertragung mit Bezug auf die laterale Richtung angeordnet. Die Windungsstruktur 12 kann in einem zentralen Abschnitt des Innenvolumens des Gehäuses im geschlossenen Zustand angeordnet sein.

Weiter dargestellt ist, dass die Empfangsvorrichtung ein erstes magnetisches Schirmelement 13a und ein zweites magnetisches Schirmelement 13b umfasst. Ein magnetisches Schirmelement bezeichnet hierbei ein Element zur Abschirmung des magnetischen Felds. Die magnetischen Schirmelemente 13a, 13b können als Aluminiumplatten ausgebildet sein. Weiter können die magnetischen Schirmelemente 13a, 13b an dem Bodenteil 3 befestigt sein. Insbesondere können die magnetischen Schirmelemente 13a, 13b in Vertiefungen an einer Bodenseite des Bodenteils angeordnet sein. Weiter kann eine Unterseite der magnetischen Schirmelemente 13a, 13b bündig mit einer Unterseite des Bodenteils 3 angeordnet sein. Das erste magnetische Schirmelement 13a deckt den ersten Aufnahmebereich 9a vollständig von unten ab. Mit anderen Worten ist das erste magnetische Schirmelement 13a unterhalb des ersten Aufnahmebereichs 9a mit Bezug auf die vertikale Richtung angeordnet. Weiter ist das erste magnetische Schirmelement 13a derart angeordnet, dass der erste Aufnahmebereich 9a, insbesondere die erste Leiterplatte 10a, die im ersten Aufnahmebereich 9a angeordnet ist, vollständig von unten von einem magnetischen Feld abgeschirmt ist. Somit ergibt sich, dass eine Menge von magnetischen Feldlinien, die sich durch die Aufnahmebereiche 9a, 9b erstrecken, wenn ein elektromagnetisches Wechselfeld zur Leistungsübertragung bereitgestellt wird, minimiert oder sogar auf Null reduziert wird. Die magnetischen Schirmelemente 13a, 13b sind derart angeordnet, dass eine Wechselwirkung von elektrischen und/oder elektronischen Elementen, insbesondere Elementen der Leiterplatten 10a, 10b, mit dem elektromagnetischen Feld zur Leistungsübertragung minimiert werden.

Die erste Leiterplatte 10a kann auch als Niedrigspannungs-Leiterplatte bezeichnet werden. Dies kann bedeuten, dass elektrische und elektronische Komponenten der ersten Leiterplatte 10a mit einer Maximalspannung von 12 V oder 42 V versorgt werden können oder eine solche Spannung bereitstellen. Die zweite Leiterplatte 10b kann auch als Hochspannungs-Leiterplatte bezeichnet werden. Dies kann bedeuten, dass elektrische und elektronische Komponenten der zweiten Leiterplatte 10b mit einer Maximalspannung von bis zu 1.200 V versorgt werden können oder eine solche Spannung bereitstellen.

So können Komponenten der ersten Leiterplatte 10a Steuerungsmittel zur Steuerung eines Betriebes der Empfangsvorrichtung 1 und Kommunikationsmittel zur Bereitstellung einer Kommunikation mit dem Fahrzeug und/oder einer Primäreinheit bereitstellen. Komponenten der zweiten Leiterplatte 10b können eine gewünschte Gleichspannung der Empfangsvorrichtung 1 aus der Wechselspannung bereitstellen, die in der Windungsstruktur 12 durch das elektromagnetische Feld zur Leistungsübertragung induziert wird.

Weiter dargestellt ist ein erster Stecker 14a, durch den eine Signal- und eine Datenverbindung zu Komponenten der ersten Leiterplatte 10a hergestellt werden kann. Der erste Stecker 14a kann z.B. als CAN-Stecker ausgebildet sein. Zumindest ein Teil des ersten Steckers 14a ist hierbei an einer äußeren Oberfläche einer Seitenwand des Deckelteils 2 angeordnet. Weiter dargestellt ist ein zweiter Stecker 14b, der auch als Leistungsstecker oder Gleichspannungs-Schnittstelle bezeichnet werden kann. Durch den zweiten Stecker 14b kann eine Verbindung zur Leistungsübertragung und, gegebenenfalls, zur Signalübertragung zwischen Komponenten der zweiten Leiterplatte 10b und dem Fahrzeug hergestellt werden. Der zweite Stecker 14b kann ebenfalls an einer äußeren Oberfläche einer Seitenwand des Deckelteils angeordnet sein. Der zweite Stecker 14b kann ein Stecker mit Kabelverschraubung sein, um die Abdichtung des Innenvolumens des Gehäuses im geschlossenen Zustand zu gewährleisten.

Weiter dargestellt ist eine Nut 15 einer Feder-Nut-Verbindung. Die Nut 15 ist hierbei in einem Randbereich des Deckelteils 2 angeordnet. Insbesondere ist die Nut 15 eine umlaufende Nut. Die Nut 15 dient zur Aufnahme eines Dichtelements, insbesondere eines umlaufenden Dichtelements (nicht dargestellt).

Das Bodenteil 3 weist eine korrespondierende als Steg 16 ausgebildete Feder der Nut-Feder-Verbindung auf. Die Feder 16 ist in einem Randbereich des Bodenteils 3 und an einer Oberseite des Bodenteils 3 angeordnet. Insbesondere wird die Feder 16 durch einen Steg bereitgestellt, der von der Oberseite des Bodenteils 3 absteht.

Im geschlossenen Zustand des Gehäuses erstreckt sich die Feder 16 in die Nut 15 und verklemmt das Dichtelement in der Nut 15.

Auf diese Weise kann eine robuste und zuverlässige Abdichtung des Innenvolumens des Gehäuses, in dem die Leiterplatten 10a, 10b und die Windungsstruktur 12 angeordnet sind, hergestellt werden. Auch die Feder 16 kann als umlaufende Feder ausgebildet sein.

Weiter dargestellt sind Ferritstäbe 17, die Teil einer Ferritanordnung sind, und magnetisch leitfähige Elemente bereitstellen. Hierbei ist dargestellt, dass die Ferritstäbe 17 in und auf der Windungsstruktur 12, insbesondere über einem zentralen Abschnitt der Windungsstruktur 12, angeordnet sind. Die Ferritstäbe 17 und die Windungsstruktur 12 können an dem Bodenteil 3 befestigt sein. Insbesondere können die Windungsstruktur 12 und die Ferritstäbe 17 mit dem Bodenteil 3 vergossen sein. Die Ferritstäbe 17 können derart angeordnet sein, dass ein gewünschter Verlauf von Feldlinien des magnetischen Feldes hergestellt wird.

Weiter dargestellt ist ein Wärmeleitpad 18, welches ein wärmeleitfähiges Element bildet. Das Wärmeleitpad 18 ist auf den Ferritstäben 17 angeordnet. Das Wärmeleitpad 18 kann eine hohe thermische Leitfähigkeit aufweisen. Im geschlossenen Zustand des Gehäuses kann das Wärmeleitpad einen innenliegenden Abschnitt einer Gehäusewand und die Ferritstäbe 17 kontaktieren und somit eine thermische Verbindung zwischen den Ferritelementen 17 und dem Deckelteil 2 herstellen.

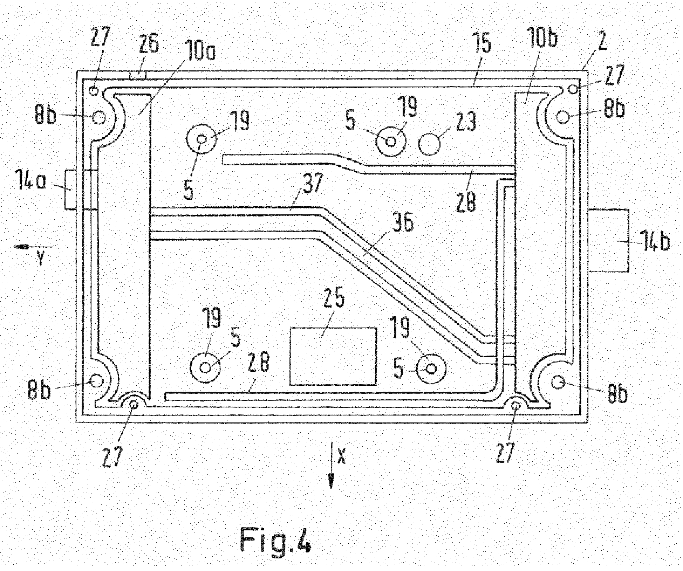

Weiter kann das Wärmeleitpad 18 ein Klebeelement bereitstellen. Es ist z.B. möglich, dass das Wärmeleitpad als doppelseitiges Klebeelement oder einseitiges Klebeelement ausgebildet ist. Somit kann das Wärmeleitpad 18 genutzt werden, um ein Flachbandkabel 36 in einer Aufnahmenut 37 des Deckelteils 2 (siehe Fig. 4) zu sichern. Alternativ zum Flachbandkabel 36 kann auch eine flexible Leiterplatte in der Aufnahmenut 37 verwendet werden.

Mit anderen Worten kann die Empfangsvorrichtung 1 zumindest ein wärmeleitfähiges Element umfassen, wobei das wärmeleitfähige Element eine thermische Verbindung zwischen dem Deckelteil 2 und der Windungsstruktur 12 oder einer Ferritanordnung in einem geschlossenen Zustand des Gehäuses herstellt. Insbesondere kann das wärmeleitfähige Element das Deckelteil 2 und die Windungsstruktur 12 oder die Ferritanordnung mechanisch kontaktieren.

Fig. 2 zeigt einen schematischen Querschnitt durch ein Deckelteil 2. Dargestellt sind die Leiterplatten 10a, 10b, die an dem Deckelteil 2 durch Schrauben 11 befestigt sind. Weiter dargestellt ist die Nut 15 der Nut-Feder-Verbindung. Weiter dargestellt sind zylinderförmige Erhebungen 19 auf einer Unterseite des Deckelteils 2, die einen Gewindeabschnitt zur Aufnahme der Schrauben 11 zur Befestigung des Bodenteils 3 an dem Deckelteil 2 umfassen.

Weiter dargestellt sind konische Erhebungen 20 des Deckelteils 2, insbesondere an einer Unterseite des Deckelteils 2, die sich in das Innenvolumen 6 des Deckelteils 2 erstrecken und die Gewinde für die Schrauben 11 zur Befestigung der Leiterplatten 10a, 10b an dem Deckelteil 2 bereitstellen. Diese konischen Erhebungen 20 sind jeweils in den Aufnahmebereichen 9a, 9b angeordnet und erstrecken sich durch Durchgangslöcher in den Leiterplatten 10a, 10b (nicht dargestellt). Dies erlaubt in vorteilhafter Weise das Ausrichten der Leiterplatten 10a, 10b in dem entsprechenden Aufnahmebereich 9a, 9b. Weiter dargestellt sind Kühlstäbe 21, die an einer Oberseite des Deckelteils 2 angeordnet sind. Die Kühlstäbe 21 können unterschiedliche Längen aufweisen. Die Länge kann hierbei entsprechend von Bauraumbedingungen gewählt werden. Alternativ oder kumulativ zu den Kühlstäben 21 ist es auch möglich, dass Kühlrippen an der Oberseite des Deckelteils 2 angeordnet sind.

Die Kühlstäbe 21 können in einem zentralen Abschnitt des Deckelteils 2 angeordnet sein. Insbesondere können die Kühlstäbe 21 außerhalb von Volumina angeordnet sein, die über den Aufnahmebereichen 9a, 9b oder über den Leiterplatten 10a, 10b angeordnet sind. Die Kühlstäbe 21 ermöglichen eine Übertragung von thermischer Energie von dem Deckelteil 2 in eine Umgebung durch Konvektion.

Fig. 3 zeigt eine schematische Draufsicht auf ein Deckelteil 2. Dargestellt sind die Durchgangslöcher 8b zur Aufnahme von Schrauben, um die Empfangsvorrichtung 1 an dem Fahrzeug zu befestigen. Weiter dargestellt sind Kühlstäbe 21, die von einer Oberseite des Deckelteils 2 abstehen. Weiter dargestellt sind Vertiefungen 22 in der Oberseite des Deckelteils 2. Diese Vertiefungen 22 verringern ein Innenvolumen des Gehäuses im geschlossenen Zustand des Gehäuses. Insbesondere können die Vertiefungen 22 eine Luftmenge im Innenvolumen der Empfangsvorrichtung 1 verringern. Dies wiederum kann eine Druckänderung eines Druckes in dem Innenvolumen aufgrund von Temperaturänderungen verringern. Es ist möglich, dass Temperaturen in der Empfangsvorrichtung 1 zwischen -40°C und 120°C variieren. Diese Temperaturänderungen können von einer Temperaturänderung der Außentemperatur und von thermischer Energie, die durch elektrische und elektronische Komponenten im Innenvolumen erzeugt wird, insbesondere von Komponenten der zweiten Leiterplatte 10b, abhängen. Die Temperaturänderungen können in einer Druckänderung des Druckes im Innenvolumen resultieren. Eine Reduktion des Innenvolumens erlaubt somit in vorteilhafter Weise die Reduktion einer Höhe der Druckänderung.

Weiter dargestellt ist ein erstes Membranelement 23. Das erste Membranelement 23 ist als semipermeables, dampfdurchlässiges Element ausgebildet. Insbesondere ermöglicht das dampfdurchlässige Membranelement 23, dass Dampf aus dem Innenvolumen der Empfangsvorrichtung in einem geschlossenen Zustand des Gehäuses durch das Membranelement 23 austreten kann. Das erste Membranelement 23 erstreckt sich durch das Deckelteil 2. Auf der Oberseite des Deckelteils 2 ist das Membranelement 23 in einer geneigten Rille 24 für einen Wasserabfluss angeordnet.

Weiter dargestellt ist ein zweites Membranelement 25. Das zweite Membranelement wird durch ein flexibles, nicht permeables, insbesondere nicht dampfdurchlässiges, Material bereitgestellt, beispielsweise durch Gummi. Das zweite Membranelement ermöglicht in vorteilhafter Weise eine Änderung des Innenvolumens der Empfangsvorrichtung 1 im geschlossenen Zustand des Gehäuses. Aufgrund der vorhergehend beschriebenen Temperaturänderungen kann ein Druck im Innenvolumen einen maximal zulässigen Druck übersteigen. Das zweite Membranelement 25 kann insbesondere derart ausgebildet sein, dass es sich bei einem Druck, der höher als ein vorbestimmter Druck ist, verformt.

Insbesondere wenn das erste Membranelement 23 keine Diffusion von Dampf aus dem Innenvolumen des Gehäuses in eine Umgebung zulässt, ermöglicht das zweite Membranelement 25 durch eine Verformung, dass der Druck im Innenvolumen in bestimmten Grenzen liegt.. Eine Dampfdiffusion kann beispielsweise dann nicht möglich sein, wenn das erste Membranelement 23 mit Wasser bedeckt ist, beispielsweise wenn das Fahrzeug durch eine tiefe Pfütze fährt.

Fig. 4 zeigt eine schematische Unteransicht eines Deckelteils 2. Dargestellt sind die Leiterplatten 10a, 10b. Ein Randbereich des Deckelteils 2, insbesondere ein Randbereich, der die erste Leiterplatte 10a einschließt, weist eine Vertiefung 26 zur Aufnahme einer Zunge 32 (siehe Fig. 5) des ersten magnetischen Schirmelements 13a auf. Die Zunge 32 verbindet das erste magnetische Schirmelement 13a mit dem Deckelteil 2 und stellt somit eine elektrische Verbindung zwischen dem ersten Schirmelement 13a und somit zu dem Referenzpotential des Fahrzeuges her.

Weiter dargestellt sind zylindrische Erhebungen 19 mit dem Gewindeabschnitt 5. Weiter dargestellt sind das erste und das zweite Membranelement 23, 25. Weiter dargestellt sind Gewindeabschnitte 27 in dem Deckelteil 2, die ein Verschrauben des Bodenteils 3 mit dem Deckelteil 2 ermöglichen. Weiter dargestellt ist die Nut 15 der Nut-Feder-Verbindung, die die Leiterplatten 10a, 10b und einen zentralen Abschnitt des Deckelteils 2 umfasst.

Weiter dargestellt ist eine Aufnahmenut 37 zur Aufnahme eines Flachbandkabels 36. Das Flachbandkabel 36 stellt eine Daten- und Signalverbindung zwischen Komponenten der ersten Leiterplatte 10a und Komponenten der zweiten Leiterplatte 10b her. Das Flachbandkabel 36 kann in der Aufnahmenut 37 durch Klebeelemente gesichert werden. Hierbei ist möglich, dass die Klebeelemente durch Wärmeleitpads 18 (siehe Fig. 1) bereitgestellt werden.

Weiter dargestellt sind Wärmeleitrohre 28, wobei die Wärmeleitrohre 28 sich von der zweiten Leiterplatte 10b in den zentralen Bereich des Deckelteils 2 erstrecken. Insbesondere erstrecken sich die Wärmeleitrohre 28 von der zweiten Leiterplatte 10b in einen Bereich unterhalb der Kühlstäbe 21 (siehe Fig. 2 und Fig. 3). Die Wärmeleitrohre 28 ermöglichen eine Übertragung von thermischer Energie von der zweiten Leiterplatte 10b, insbesondere von wärmegenerierenden Komponenten der zweiten Leiterplatte 10b, wie z.B. leistungselektronischen Komponenten, in den zentralen Bereich. Dies wiederum ermöglicht die Verteilung von thermischer Energie innerhalb der Empfangsvorrichtung 1, was in vorteilhafter Weise eine thermische Belastung der zweiten Leiterplatte 10b und deren Komponenten reduziert.

Die Wärmeleitrohre können in Aufnahmenuten des Deckelteils 2, insbesondere in Aufnahmenuten in inneren Wandabschnitten des Deckelteils 2 angeordnet sein.

Fig. 5 zeigt eine schematische Draufsicht auf ein Bodenteil 3. Dargestellt sind die Durchgangslöcher 4 und weitere Durchgangslöcher 29 zur Bereitstellung einer Schraubverbindung zwischen dem Bodenteil 3 und dem Deckelteil 2. Weiter dargestellt sind die Durchgangslöcher 8a zur Bereitstellung einer Schraubverbindung der Empfangsvorrichtung 1 mit dem Fahrzeug. Weiter dargestellt ist die Feder 16 (siehe auch Fig. 6) der Nut-Feder-Verbindung. Durch Strichlinien dargestellt sind die magnetischen Schirmelemente 13a, 13b.

Weiter dargestellt sind Stege 30, die von einer Oberseite des Bodenteils 3 abstehen. Diese Stege 30 umfassen einen Aufnahmebereich für die Windungsstruktur 12 und für die Ferritstäbe 17 (siehe Fig. 1) und legen somit den Aufnahmebereich fest. Weiter erhöhen die abstehenden Stege eine mechanische Stabilität des Bodenteils 3.

Die abstehenden Stege 30 sind in einem zentralen Bereich des Bodenteils 3 angeordnet, insbesondere in einem Bereich zwischen den Volumina über den magnetischen Schirmelementen 13a, 13b.

Weiter dargestellt sind zylinderförmige Erhebungen 31 auf einer Oberseite des Bodenteils 3. Diese Erhebungen 31 sind in den Aufnahmebereichen für die Ferritstäbe 17 angeordnet. Der Übersichtlichkeit halber sind nur zwei zylinderförmige Erhebungen 31 mit einem Bezugszeichen versehen. Diese zylinderförmigen Erhebungen 31 dienen als Abstandshalterelemente, um einen gewünschten Abstand zwischen einer Oberseite des Bodenteils 3 und einer Unterseite eines Ferritstabes 17 bereitzustellen.

Weiter dargestellt ist eine Zunge 32, die das erste magnetische Schirmelement 13a elektrisch mit dem Deckelteil 2 verbindet. Weiter dargestellt ist eine Zunge 33, die das zweite magnetische Schirmelement 13 mit dem Deckelteil 2 verbindet.

Fig. 6 zeigt einen schematischen Längsschnitt durch ein Bodenteil 3. Dargestellt ist die Nut der Nut-Feder-Verbindung zwischen dem Bodenteil 3 und dem Deckelteil 2. Weiter dargestellt ist das zweite magnetische Schirmelement 13b mit der Zunge 33.

Weiter dargestellt ist die Windungsstruktur 12, wobei die Windungsstruktur 12 durch eine vorhergehend erläuterte Doppel-D-Windungsstruktur bereitgestellt wird. Weiter dargestellt sind Ferritstäbe 17, wobei untere Ferritstäbe 17a unterhalb von einem oberen Ferritstab 17b angeordnet sind. Die Anordnung der Ferritstäbe 17a, 17b stellt eine Ausnehmung 34 zur Aufnahme eines zentralen Abschnitts der Windungsstruktur 12 bereit.

Weiter dargestellt ist ein Antennenelement 35, welches durch eine Antennenwindungsstruktur bereitgestellt wird, die um einen der unteren Ferritstäbe 17a gewickelt ist. Das Antennenelement 35 kann zur Herstellung einer drahtlosen Signalverbindung zwischen Komponenten der ersten Leiterplatte 10a und einer Primäreinheit dienen.

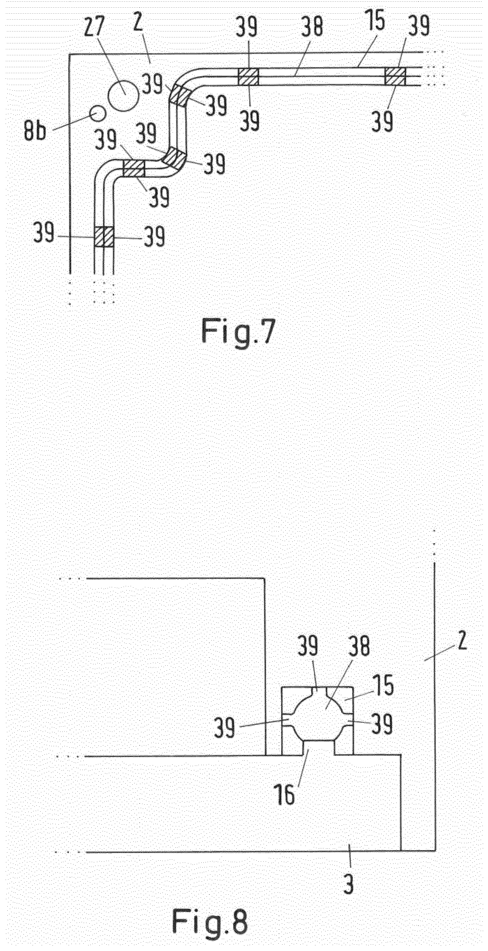

Fig. 7 zeigt eine detaillierte Unteransicht eines Deckelteils 2 mit einem Gewindeabschnitt 27 und einer Durchgangsöffnung 8b. Weiter dargestellt ist eine Nut 15 einer Nut-Feder-Verbindung mit einem darin angeordneten Dichtelement 38. Entlang seines Verlaufs weist das Dichtelement an einer äußeren Oberfläche Erhebungen 39 auf. Die Erhebungen 39 stehen in Richtung hin zu Seitenwänden der Nut 15 von einem zentralen Abschnitt des Dichtelements 38 ab. Hierbei ist dargestellt, dass entlang eines Verlaufs des zentralen Abschnitts des Dichtelements 38 im gleichen Teilabschnitt des Dichtelements 38 jeweils eine Erhebung 39, die in Richtung einer ersten Seitenwand der Nut 15 absteht, und eine Erhebung 39, die in Richtung einer zweiten, der ersten Seitenwand gegenüberliegenden Seitenwand, der Nut 15 absteht, angeordnet ist. Somit weist das Dichtelement 38 entlang des Verlaufs des zentralen Abschnitts des Dichtelements 38 Teilabschnitte auf, in dem Erhebungen 39 hin zu beiden Seitenwänden der Nut 15 abstehen.

Diese Erhebungen 39 dienen einer Zentrierung des Dichtelements 38 in der Nut 15. Weiter dargestellt ist, dass eine räumliche Dichte von Erhebungen 39 in einem gekrümmten Abschnitt des Dichtelements 38 größer als eine räumliche Dichte in einem geraden Abschnitt des Dichtelements 38 ist.

Fig. 8 zeigt einen detaillierten Querschnitt durch ein geschlossenes Gehäuse außerhalb eines Steckeraufnahmebereichs. Dargestellt sind das Deckelteil 2 und das Bodenteil 3. Das Deckelteil 2 weist eine Nut 15 einer Nut-Feder-Verbindung auf, die auch zur Aufnahme eines Dichtelements 38 mit Erhebungen 39 an der Außenseite dient Dargestellt ist auch der Steg, der die Feder 16 der Nut-Feder-Verbindung ausbildet, wobei der Steg von dem Bodenteil 3 ausgebildet wird.

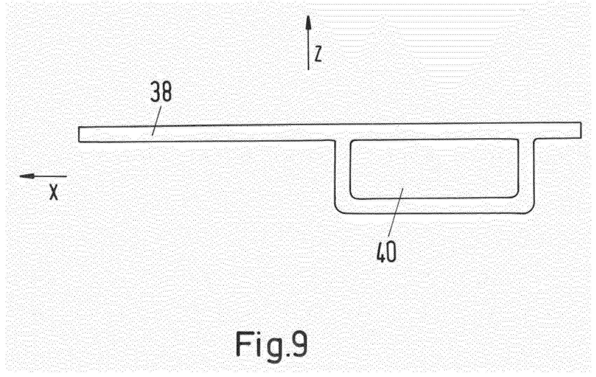

Fig. 9 zeigt eine schematische Seitenansicht eines Dichtelements 38. Dargestellt ist, dass das Dichtelement 38 eine Durchgangsöffnung 40 ausbildet. Durch diese Durchgangsöffnung kann sich z.B. der erste Stecker 14a (siehe z.B. Fig. 1) erstrecken, um so aus dem abgedichteten Innenvolumen an die Außenseite herausgeführt zu werden.

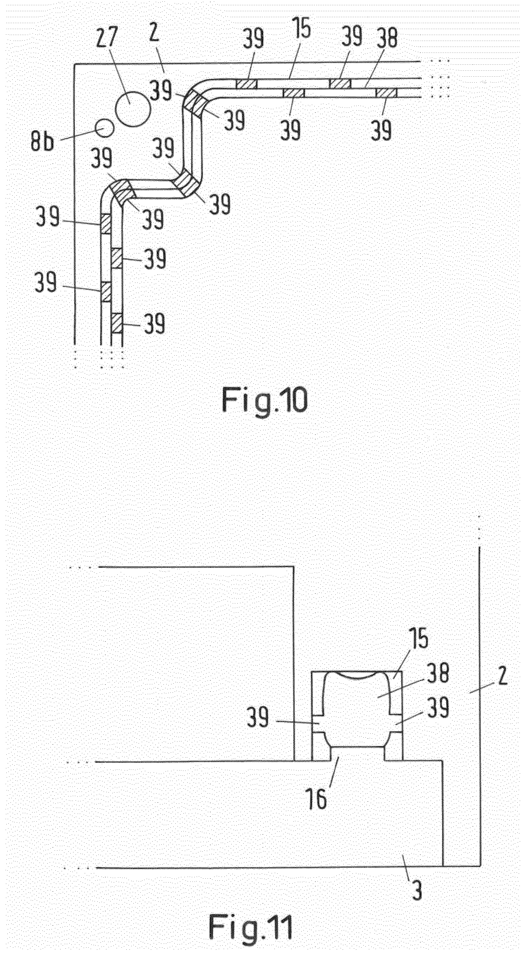

Fig. 10 zeigt eine detaillierte Unteransicht eines Deckelteils 2 mit einem Gewindeabschnitt 27 und einer Durchgangsöffnung 8b in einer weiteren Ausführungsform. Weiter dargestellt ist eine Nut 15 einer Nut-Feder-Verbindung mit einem darin angeordneten Dichtelement 38. Entlang seines Verlaufs weist das Dichtelement an einer äußeren Oberfläche Erhebungen 39 auf. Im Unterschied zu der in Fig. 7 dargestellten Ausführungsform weisen nur gekrümmte Abschnitte, also ungeraden Abschnitte, des Verlaufs des zentralen Abschnitts des Dichtelements 38 Teilabschnitte auf, in dem Erhebungen 39 hin zu beiden Seitenwänden der Nut 15 abstehen. In ungekrümmten, also geraden Abschnitten, des Verlaufs des zentralen Abschnitts sind Erhebungen 39, die hin zur ersten Seitenwand der Nut 15 abstehen, entlang des Verlaufs des Dichtelements 38 versetzt zu Erhebungen 39, die hin zur zweiten Seitenwand der Nut 15 abstehen, angeordnet. Insbesondere kann in einem solchen ungekrümmten Abschnitt in einem ersten Teilabschnitt eine Erhebung 39 hin zu einer ersten Seitenwand der Nut 15 abstehen, wobei in diesem ersten Teilabschnitt keine Erhebung 39 hin zu der zweiten Seitenwand absteht. Weiter kann in einem entlang des Verlaufs weiteren Teilabschnitt dann eine Erhebung 39 hin zur zweiten Seitenwand abstehen, wobei in diesem weiteren Teilabschnitt keine Erhebung 39 hin zur ersten Seitenwand absteht. Mit anderen Worten sind die zu verschiedenen Seitenwänden der Nut 15 abstehenden Erhebungen 39 in ungekrümmten Abschnitten des zentralen Abschnitts des Dichtelements 38 entlang des Verlaufs alternierend zueinander angeordnet. Eine solche Ausführungsform erschwert in vorteilhafter Weise ein Verkippen des Dichtelements 38 in der Nut 15.

Fig. 11 zeigt einen detaillierten Querschnitt durch ein geschlossenes Gehäuse außerhalb eines Steckeraufnahmebereichs. Dargestellt ist das Deckelteil 2 und das Bodenteil 3. Das Deckelteil 2 weist eine Nut 15 einer Nut-Feder-Verbindung auf, die auch zur Aufnahme eines Dichtelements 38 mit Erhebungen 39 an der Außenseite dient. Im Unterschied zu der in Fig. 9 dargestellten Ausführungsform weist das Dichtelement 38 nur Erhebungen auf, die in Richtung von Seitenwänden der Nut 15 abstehen. An einer Unterseite des Dichtelements 38 weist dieses einen Doppellippenabschnitt auf oder bildet diesen aus, wobei durch den Doppellippenabschnitt zwei Kontaktabschnitte des Dichtelements 38 mit einer Bodenfläche der Nut 15 bereitgestellt werden. Die Unterseite des Dichtelements 38 kann hierbei die Seite bezeichnen, die im zusammengesetzten Zustand die Bodenfläche der Nut 15 kontaktiert. An einer Oberseite des Dichtelements 38 weist dieses einen Einfachlippenabschnitt auf oder bildet diesen aus, wobei durch den Einfachlippenabschnitt nur ein Kontaktabschnitt mit dem Bodenteil 3 bereitgestellt wird. Die Oberseite des Dichtelements 38 kann hierbei die Seite bezeichnen, die im zusammengesetzten Zustand die das Bodenteil 3 kontaktiert.

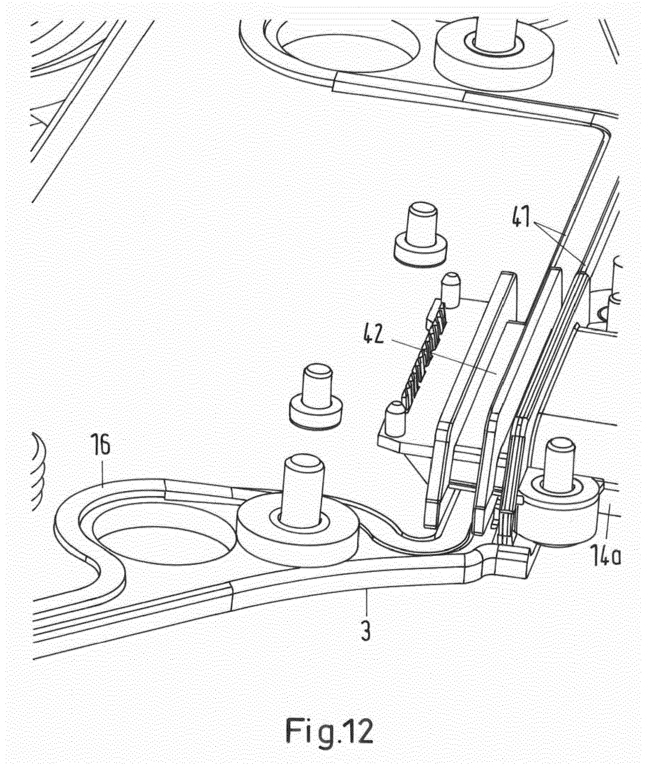

Fig. 12 zeigt eine perspektivische Ansicht eines Randabschnitts eines Bodenteils 3. In dem Randabschnitt weist das Bodenteil 3 einen Steg 16 auf, wobei der Steg 16 entlang seines Verlaufs eine sich verändernde Höhe über einer Oberseite des Bodenteils 3 aufweist. Hierbei ist dargestellt, dass sich die Höhe mit einem rampenförmigen Verlauf verändert. Insbesondere geht der Steg 16 entlang seines Verlaufs in einen nut- und stegfreien Bereich über, wobei dieser durch eine Freischneidung im Bereich der Oberseite des Bodenteils 3 ausgebildet wird und eine Höhe über der Oberseite von Null aufweist. Dieser Bereich geht entlang seines Verlaufs wieder in einen Steg 16 über. Die Freischneidung wird hierbei durch Vertiefungen 41 im Bereich der Oberseite gebildet. Dieser nut- und stegfreie Bereich mit einer Höhe von Null über der Oberseite kann insbesondere in einem Steckeraufnahmebereich des Bodenteils 3 angeordnet sein.

Weiter dargestellt ist ein erster Stecker 14a. Der erste Stecker 14a bildet hierbei Nuten 42 zur Aufnahme eines in Fig. 12 nicht dargestellten Dichtelements 38 aus. Der erste Stecker 14a kann sich insbesondere durch eine Durchgangsöffnung 40 des in Fig. 9 dargestellten Dichtelements 38 erstrecken, wobei die Abschnitte des Dichtelements 38, welche die Durchgangsöffnung umfassen, in den Nuten 42 angeordnet sind.

In den Abschnitten, in denen der Steg 16 nicht die maximale Höhe über der Oberseite des Bodenteils 3 aufweist, kann das Dichtelement 38 nicht oder nicht vollständig durch den Steg 16 in eine korrespondierende Nut 15 im Deckelteil 2 eingepresst werden. Es ist somit möglich, dass in solchen Abschnitten das Dichtelement 38 über obere Ränder der Nut 15 übersteht bzw. aus der Nut 15 herausragt.

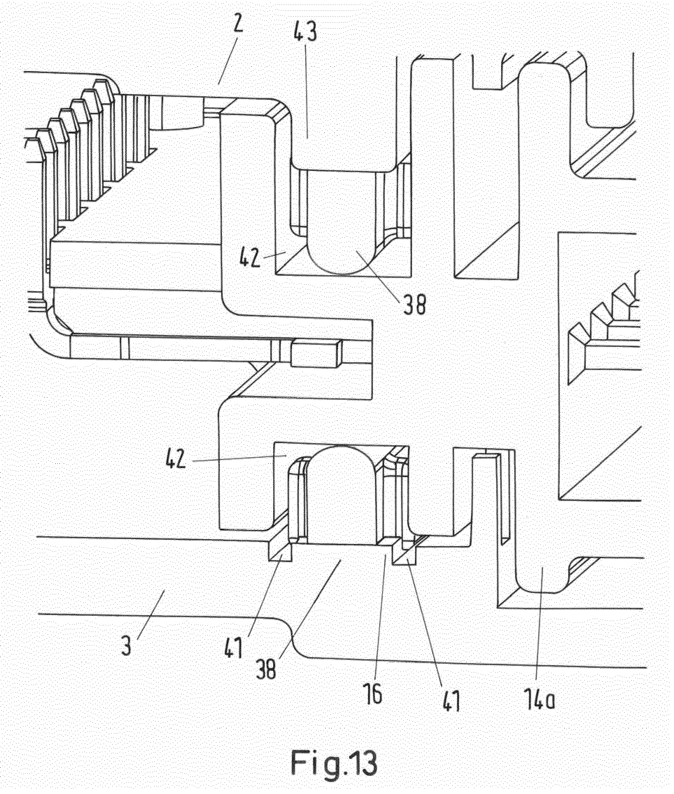

Fig. 13 zeigt einen Querschnitt durch ein geschlossenes Gehäuse in einem Steckeraufnahmebereich. Dargestellt sind ein Bodenteil 3 und ein Deckelteil 2. Weiter dargestellt ist ein erster Stecker 14a, der Nuten 42 zur Aufnahme eines Dichtelements 38 aufweist oder ausbildet. Hierbei erstreckt sich der erste Stecker 14a durch eine Durchgangsöffnung 40 des in Fig. 9 dargestellten Dichtelements 38, wobei die Abschnitte des Dichtelements 38, welche die Durchgangsöffnung 40 umfassen, in den Nuten 42 angeordnet sind. Dargestellt ist ein nut- und stegfreier Bereich des Bodenteils, in den der Steg 16 entlang seines Verlaufs übergeht und der entlang seines Verlaufs wieder in einen Steg 16 übergeht. Dieser Bereich ist durch Vertiefungen 41 im Bereich der Oberseite des Bodenteils 3 freigeschnitten ist.

Weiter dargestellt ist, dass das Deckelteil einen Steg 43 ausbildet, der im geschlossenen Zustand des Gehäuses von einer Nut 42 des ersten Steckers 14a aufgenommen wird. Somit kann das Deckelteil 2 zusätzlich zu der z.B. in Fig. 8 dargestellten Nut 15 den Steg 43 ausbilden. Es ist möglich, dass das Deckelteil 2 nur im Steckeraufnahmebereich den Steg 43 ausbildet. In verbleibenden Bereichen kann das Deckelteil 2 die Nut 15 ausbilden. Insbesondere kann die Nut 15 entlang ihres Verlaufs in den Steg 43 übergehen. Auch kann der Steg 43 entlang seines Verlaufs in eine Nut 15 übergehen.

Die in Fig. 12 und Fig. 13 dargestellte Ausführungsform ermöglicht die zuverlässige Aufnahme des ersten Steckers 14a bei möglichst geringer Bauhöhe des Gehäuses im geschlossenen Zustand. Insbesondere ist sichergestellt, dass sich der erste Stecker 14a in das Gehäuse hineinerstrecken kann, wobei das Innenvolumen auch im Steckeraufnahmebereich gegenüber dem Außenvolumen zuverlässig abgedichtet ist.

### Bezugszeichenliste

- 1: Empfangsvorrichtung
- 2: Deckelteil
- 3: Bodenteil
- 4: Durchgangsöffnung
- 5: Gewindeabschnitt
- 6: Innenvolumen
- 7: Seitenwände
- 8a, 8b: Durchgangsöffnung
- 9a, 9b: Aufnahmebereiche
- 10a, 10b: Leiterplatte
- 11: Schraube
- 12: Windungsstruktur
- 13a, 13b: magnetisches Schirmelement
- 14a, 14b: Stecker
- 15: Nut
- 16: Steg
- 17: Ferritstab
- 17a, 17b: Ferritstab
- 18: Wärmeleitpad
- 19: zylinderförmige Erhebung
- 20: konische Erhebung
- 21: Kühlstab
- 22: Ausnehmung
- 23: erstes Membranelement
- 24: Rille
- 25: zweites Membranelement
- 26: Nut
- 27: Gewindeabschnitt
- 28: Wärmeleitrohr
- 29: Durchgangsöffnung
- 30: Steg
- 31: zylinderförmige Erhebung
- 32: Zunge
- 33: Zunge
- 34: Ausnehmung
- 35: Antennenelement
- 36: Flachbandkabel
- 37: Aufnahmenut
- 38: Dichtelement
- 39: Erhebung
- 40: Öffnung
- 41: Vertiefung
- 42: Nut
- 43: Steg

## Patentansprüche

1. Empfangsvorrichtung für ein System zur induktiven Leistungsübertragung, wobei die Empfangsvorrichtung (1) eine Windungsstruktur (12) und ein Gehäuse umfasst, wobei das Gehäuse als Gehäuseteile einen Deckelteil (2) und einen Bodenteil (3) umfasst, wobei das Gehäuse ein Innenvolumen zur Aufnahme der Windungsstruktur (12) aufweist, wobei eines der Gehäuseteile mindestens einen Steg (16) und das verbleibende Gehäuseteil mindestens eine Nut (15) zur Aufnahme des mindestens einen Stegs (16) aufweist, wobei der mindestens eine Steg (16) und die mindestens eine Nut (15) zwischen dem Innenvolumen und einem Außenvolumen angeordnet sind, wobei die Empfangsvorrichtung (1) mindestens ein Dichtelement (38) umfasst, wobei zumindest ein Abschnitt des mindestens einen Stegs (16) und zumindest ein Abschnitt des mindestens einen Dichtelements (38) in zumindest einem Abschnitt der mindestens einen Nut (38) angeordnet sind, wobei die Empfangsvorrichtung (1) mindestens ein Signalverbindungselement umfasst, wobei sich das Signalverbindungselement von dem Innenvolumen in das Außenvolumen erstreckt, wobei sich das Signalverbindungselement durch das mindestens eine Dichtelement (38) hindurch erstreckt.

2. Empfangsvorrichtung nach Anspruch 1, **dadurch gekennzeichnet, dass** zumindest eines der Gehäuseteile (2, 3) mindestens ein Befestigungsmittel zur Befestigung der Gehäuseteile (2, 3) aneinander aufweist, wobei das mindestens eine Befestigungsmittel außerhalb des abgedichteten Innenvolumens angeordnet ist.

3. Empfangsvorrichtung nach einem der vorangegangenen Ansprüche, **dadurch gekennzeichnet, dass** zumindest eines der Gehäuseteile (2, 3) ein erstes Membranelement (23) aufweist.

4. Empfangsvorrichtung nach Anspruch 3, **dadurch gekennzeichnet, dass** das erste Membranelement (23) dampfdurchlässig ist.

5. Empfangsvorrichtung nach Anspruch 3 oder 4, **dadurch gekennzeichnet, dass** zumindest eines der Gehäuseteile (2, 3) mindestens ein weiteres Membranelement (25) umfasst.

6. Empfangsvorrichtung nach Anspruch 5, **dadurch gekennzeichnet, dass** das weitere Membranelement (25) elastisch und dampfundurchlässig ist.

7. Empfangsvorrichtung nach einem der Ansprüche 3 bis 6, **dadurch gekennzeichnet, dass** ein äußeres Ende des ersten Membranelements (23) in einer Rille (24) an einer Außenseite des Gehäuses angeordnet ist.

8. Empfangsvorrichtung nach einem der vorangegangenen Ansprüche, **dadurch gekennzeichnet, dass** der mindestens eine Steg (16) und die mindestens eine Nut (15) jeweils mindestens einen konkaven Abschnitt aufweisen.

9. Empfangsvorrichtung nach einem der vorangegangenen Ansprüche, **dadurch gekennzeichnet, dass** das mindestens eine Dichtelement (38) an einer äußeren Oberfläche Erhebungen (39) aufweist.

10. Empfangsvorrichtung nach einem der vorangegangenen Ansprüche, **dadurch gekennzeichnet, dass** das mindestens eine Dichtelement (38) in einem Temperaturbereich von -40°C bis +120°C elastisch ist.

11. Verfahren zur Herstellung einer Empfangsvorrichtung für ein System zur induktiven Leistungsübertragung, wobei als Gehäuseteile eines Gehäuses der Empfangsvorrichtung (1) ein Bodenteil (2) und ein Deckelteil (3) bereitgestellt werden, wobei eines der Gehäuseteile (2, 3) mindestens einen Steg (16) und das verbleibende Gehäuseteil (3, 2) mindestens eine Nut (15) zur Aufnahme des mindestens einen Stegs (16) aufweist, wobei zumindest ein Abschnitt eines Dichtelements (38) in zumindest einem Abschnitt der Nut (15) angeordnet wird, wobei das Deckelteil (2) mit dem Bodenteil (3) derart verbunden wird, dass zumindest ein Abschnitt des mindestens einen Steges (16) in zumindest einem Abschnitt der mindestens einen Nut (15) angeordnet wird und das darin angeordnete Dichtelement (38) einschließt, wobei der mindestens eine Steg (16), die mindestens eine Nut (15) und das mindestens eine Dichtelement (38) zwischen einem Innenvolumen, in welchem eine Windungsstruktur (12) aufgenommen ist, und einem Außenvolumen angeordnet sind, wobei die Empfangsvorrichtung (1) mindestens ein Signalverbindungselement umfasst, wobei sich das Signalverbindungselement von dem Innenvolumen in das Außenvolumen erstreckt, wobei sich das Signalverbindungselement durch das mindestens eine Dichtelement (38) hindurch erstreckt.

## Claims

1. A receiving device for a system for inductive power transfer, wherein the receiving device (1) comprises a winding structure (12) and a housing, the housing comprising a cover part (2) and a base part (3) as housing parts, and the housing having an internal volume for receiving the winding structure (12), one of the housing parts having at least one rib (16) and the other housing part having at least one groove (15) for receiving the at least one rib (16), the at least one rib (16) and the at least one groove (15) being arranged between the internal volume and an external volume, the receiving device (1) comprising at least one sealing element (38), at least a portion of the at least one rib (16) and at least a portion of the at least one sealing element (38) being arranged in at least a portion of the at least one groove (38), the receiving device (1) comprising at least one signal connection element, the signal connection element extending from the internal volume into the external volume, and the signal connection element extending through the at least one sealing element (38).

2. The receiving device according to claim 1, **characterised in that** at least one of the housing parts (2, 3) has at least one fastening means for fastening the housing parts (2, 3) to one another, the at least one fastening means being arranged outside the sealed internal volume.

3. The receiving device according to either one of the preceding claims, **characterised in that** at least one of the housing parts (2, 3) has a first membrane element (23).

4. The receiving device according to claim 3, **characterised in that** the first membrane element (23) is vapour-permeable.

5. The receiving device according to claim 3 or 4, **characterised in that** at least one of the housing parts (2, 3) comprises at least one further membrane element (25).

6. The receiving device according to claim 5, **characterised in that** the further membrane element (25) is elastic and vapour-impermeable.

7. The receiving device according to any one of claims 3 to 6, **characterised in that** an outer end of the first membrane element (23) is arranged in a channel (24) on an outer side of the housing.

8. The receiving device according to any one of the preceding claims, **characterised in that** the at least one rib (16) and the at least one groove (15) each have at least one concave portion.

9. The receiving device according to any one of the preceding claims, **characterised in that** the at least one sealing element (38) has protrusions (39) on an outer surface.

10. The receiving device according to any one of the preceding claims, **characterised in that** the at least one sealing element (38) is elastic in a temperature range from -40°C to +120°C.

11. A method for producing a receiving device for a system for inductive power transfer, wherein a base part (2) and a cover part (3) are provided as housing parts of a housing of the receiving device (1), one of the housing parts (2, 3) having at least one rib (16) and the other housing part (3, 2) having at least one groove (15) for receiving the at least one rib (16), at least a portion of a sealing element (38) being arranged in at least a portion of the groove (15), the cover part (2) being connected to the base part (3) in such a way that at least a portion of the at least one rib (16) is arranged in at least a portion of the at least one groove (15) and traps the sealing element (38) arranged therein, the at least one rib (16), the at least one groove (15) and the at least one sealing element (38) being arranged between an internal volume in which a winding structure (12) is received and an external volume, the receiving device (1) comprising at least one signal connection element, the signal connection element extending from the internal volume into the external volume, and the signal connection element extending through the at least one sealing element (38).

## Revendications

1. Dispositif de réception pour un système pour la transmission de puissance par induction, dans lequel le dispositif de réception (1) comprend une structure de spire (12) et un boîtier, dans lequel le boîtier comprend en tant que parties de boîtier une partie de couvercle (2) et une partie de fond (3), dans lequel le boîtier présente un volume intérieur pour recevoir la structure de spire (12), dans lequel une des parties de boîtier présente au moins une entretoise (16) et la partie de boîtier restante présente au moins une rainure (15) pour recevoir l'au moins une entretoise (16), dans lequel l'au moins une entretoise (16) et l'au moins une rainure (15) sont disposées entre le volume intérieur et un volume extérieur, dans lequel le dispositif de réception (1) comprend au moins un élément étanche (38), dans lequel au moins une section de l'au moins une entretoise (16) et au moins une section de l'au moins un élément étanche (38) sont disposées dans au moins une section de l'au moins une rainure (38), dans lequel le dispositif de réception (1) comprend au moins un élément de liaison par signal, dans lequel l'élément de liaison par signal s'étend depuis le volume intérieur dans le volume extérieur, dans lequel l'élément de liaison par signal s'étend à travers l'au moins un élément étanche (38) .

2. Dispositif de réception selon la revendication 1, **caractérisé en ce qu'**au moins une des parties de boîtier (2, 3) présente au moins un moyen de fixation pour la fixation des parties de boîtier (2, 3) l'une au niveau de l'autre, dans lequel l'au moins un moyen de fixation est disposé à l'extérieur du volume intérieur étanchéifié.

3. Dispositif de réception selon l'une quelconque des revendications précédentes, **caractérisé en ce qu'**au moins une des parties de boîtier (2, 3) présente un premier élément à membrane (23).

4. Dispositif de réception selon la revendication 3, **caractérisé en ce que** le premier élément à membrane (23) est perméable à la vapeur.

5. Dispositif de réception selon la revendication 3 ou 4, **caractérisé en ce qu'**au moins une des parties de boîtier (2, 3) comprend au moins un autre élément à membrane (25).

6. Dispositif de réception selon la revendication 5, **caractérisé en ce que** l'autre élément à membrane (25) est élastique et imperméable à la vapeur.

7. Dispositif de réception selon l'une quelconque des revendications 3 à 6, **caractérisé en ce qu'**une extrémité extérieure du premier élément à membrane (23) est disposée dans un sillon (24) au niveau d'un côté extérieur du boîtier.

8. Dispositif de réception selon l'une quelconque des revendications précédentes, **caractérisé en ce que** l'au moins une entretoise (16) et l'au moins une rainure (15) présentent respectivement au moins une section concave.

9. Dispositif de réception selon l'une quelconque des revendications précédentes, **caractérisé en ce que** l'au moins un élément étanche (38) présente au niveau d'une surface extérieure des parties surélevées (39).

10. Dispositif de réception selon l'une quelconque des revendications précédentes, **caractérisé en ce que** l'au moins un élément étanche (38) est élastique dans une plage de températures de -40 °C à +120 °C.

11. Procédé de fabrication d'un dispositif de réception pour un système pour la transmission de puissance par induction, dans lequel une partie de fond (2) et une partie de couvercle (3) sont fournies en tant que parties de boîtier d'un boîtier du dispositif de réception (1), dans lequel une des parties de boîtier (2, 3) présente au moins une entretoise (16) et la partie de boîtier (3, 2) restante présente au moins une rainure (15) pour recevoir l'au moins une entretoise (16), dans lequel au moins une section d'un élément étanche (38) est disposée dans au moins une section de la rainure (15), dans lequel la partie de couvercle (2) est reliée à la partie de boîtier (3) de telle manière qu'au moins une section de l'au moins une entretoise (16) est disposée dans au moins une section de l'au moins une rainure (15) et renferme l'élément étanche (38) disposé dans celle-ci, dans lequel l'au moins une entretoise (16), l'au moins une rainure (15) et l'au moins un élément étanche (38) sont disposés entre un volume intérieur, dans lequel une structure de spire (12) est logée, et un volume extérieur, dans lequel le dispositif de réception (1) comprend au moins un élément de liaison par signal, dans lequel l'élément de liaison par signal s'étend depuis le volume intérieur dans le volume extérieur, dans lequel l'élément de liaison par signal s'étend à travers l'au moins un élément étanche (38).
